# EUROPÄISCHE PATENTSCHRIFT

(11) **EP 1 155 462 B1**
(45) Veröffentlichungstag und Bekanntmachung des Hinweises auf die Patenterteilung: **07.09.2005**
(21) Anmeldenummer: 00910521.4
(22) Anmeldetag: 01.02.2000
(51) Int. Cl.: H01L 43/08, G11C 11/16

(54) **SPEICHERZELLENANORDNUNG UND VERFAHREN ZU DEREN HERSTELLUNG**
STORAGE CELL ARRANGEMENT AND METHOD FOR PRODUCING THE SAME
ENSEMBLE DE CELLULES MEMOIRES ET SON PROCEDE DE PRODUCTION

(30) Priorität: 26.02.1999 DE 19908519
(43) Veröffentlichungstag der Anmeldung: 21.11.2001
(73) Patentinhaber: Infineon Technologies AG, 81669 München (DE)
(72) Erfinder: SCHWARZL, Siegfried, D-85579 Neubiberg (DE)
(74) Vertreter: Epping - Hermann - Fischer
(86) Internationale Anmeldenummer: PCT/DE2000/000310
(87) Internationale Veröffentlichungsnummer: WO 2000/052771

(56) Entgegenhaltungen:
- US-A- 5 541 868
- US-A- 5 587 943
- US-A- 5 969 978
- HU Y Z ET AL: "Chemical-mechanical polishing as an enabling technology for giant magnetoresistance devices" THIN SOLID FILMS,CH,ELSEVIER-SEQUOIA S.A. LAUSANNE, Bd. 308-309, Nr. 1-4, 31. Oktober 1997 (1997-10-31), Seiten 555-561, XP004110335 ISSN: 0040-6090

## Beschreibung

Die Erfindung betrifft eine Speicherzellenanordnung mit mindestens einem magnetoresistiven Element sowie ein Verfahren zu deren Herstellung.

Als magnetoresistives Element, auch Magnetowiderstandselement genannt, wird in der Fachwelt eine Struktur verstanden, die mindestens zwei ferromagnetische Schichten und eine dazwischen angeordnete nichtmagnetische Schicht aufweist. Je nach Aufbau der Schichtstruktur wird dabei unterschieden zwischen GMR-Element, TMR-Element und CMR-Element (siehe S. Mengel, Technologieanalyse Magnetismus, Band 2, XMR-Technologien, Herausgeber VDI Technologiezentrum Physikalische Technologien, August 1997).

Der Begriff GMR-Element wird für Schichtstrukturen verwendet, die mindestens zwei ferromagnetische Schichten und eine dazwischen angeordnete nichtmagnetische, leitende Schicht aufweisen und den sogenannten GMR (giant magnetoresistance)-Effekt zeigen. Unter dem GMR-Effekt wird die Tatsache verstanden, daß der elektrische Widerstand des GMR-Elementes abhängig davon ist, ob die Magnetisierungen in den beiden ferromagnetischen Schichten parallel oder antiparallel ausgerichtet sind. Der GMR-Effekt ist im Vergleich zum sogenannten AMR (anisotropic magnetoresistance)-Effekt groß. Als AMR-Effekt wird die Tatsache verstanden, daß der Widerstand in magnetisierten Leitern parallel und senkrecht zur Magnetisierungsrichtung verschieden ist. Bei dem AMR-Effekt handelt es sich um einen Volumeneffekt, der in ferromagnetischen Einfachschichten auftritt.

Der Begriff TMR-Element wird in der Fachwelt für Tunneling Magnetoresistance-Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nichtmagnetische Schicht bewirkt wird. Auch in diesem Fall ist der elektrische Widerstand des TMR-Elementes abhängig davon, ob die Magnetisierungen in den beiden ferromagnetischen Schichten parallel oder antiparallel ausgerichtet sind. Die relative Widerstandsänderung beträgt dabei etwa 6 bis ca. 40 Prozent bei Raumtemperatur.

Ein weiterer Magnetowiderstandseffekt, der wegen seiner Größe (relative Widerstandsänderung von 100 bis 400 Prozent bei Raumtemperatur) CMR (colossal magnetoresistance)-Effekt genannt wird, erfordert wegen seiner hohen Koerzitivkräfte ein hohes Magnetfeld zum Umschalten zwischen den Magnetisierungszuständen.

Es ist vorgeschlagen worden, (siehe zum Beispiel D. D. Tang et al, IEDM 95, Seiten 997 bis 999, J. M. Daughton, Thin Solid Films, Bd. 216 (1992), Seiten 162 bis 168, Z. Wang et al, Journal of Magnetism and Magnetic Materials, Bd. 155 (1996), Seiten 161 bis 163) GMR-Elemente als Speicherelemente in einer Speicherzellenanordnung zu verwenden. Die Speicherelemente werden über Leseleitungen in Reihe verschaltet. Quer dazu verlaufen Wortleitungen, die sowohl gegenüber den Leseleitungen als auch gegenüber den Speicherelementen isoliert sind. An die Wortleitungen angelegte Signale verursachen durch den in jeder Wortleitung fließenden Strom ein Magnetfeld, das bei hinreichender Stärke die darunter befindlichen Speicherelemente beeinflußt. Zum Einschreiben von Information werden x/y-Leitungen verwendet, die sich an der zu beschreibenden Speicherzelle kreuzen. Sie werden mit Signalen beaufschlagt, die am Kreuzungspunkt ein für die Ummagnetisierung ausreichendes magnetisches Feld verursachen. Dabei wird die Magnetisierungsrichtung in der einen der beiden ferromagnetischen Schichten umgeschaltet. Die Magnetisierungsrichtung in der anderen der beiden ferromagnetischen Schichten bleibt dagegen unverändert. Das Festhalten der Magnetisierungsrichtung in der zuletzt genannten ferromagnetischen Schicht erfolgt durch eine benachbarte antiferromagnetische Schicht, die die Magnetisierungsrichtung festhält, oder dadurch, daß die Schältschwelle für diese ferromagnetische Schicht durch anderes Material oder andere Dimensionierung, zum Beispiel die Schichtdicke, im Vergleich zu der zuerst genannten ferromagnetischen Schicht vergrößert wird.

In US 5 541 868 und US 5 477 482 sind ringförmige Speicherelemente vorgeschlagen worden, die auf dem GMR-Effekt beruhen. Ein Speicherelement umfaßt einen Stapel, der mindestens zwei ringförmige ferromagnetische Schichtelemente und ein nichtmagnetisches leitendes Schichtelement, das dazwischen angeordnet ist, aufweist und der zwischen zwei Leitungen geschaltet ist. Die ferromagnetischen Schichtelemente unterscheiden sich in ihrer Materialzusammensetzung. Eines der ferromagnetischen Schichtelemente ist magnetisch hart, das andere magnetisch weicher. Zum Einschreiben der Information wird die Magnetisierungsrichtung in dem magnetisch weicheren Schichtelement umgeschaltet, während die Magnetisierungsrichtung in dem magnetisch härteren Schichtelement erhalten bleibt.

Eine weitere Speicherzellenanordnung mit ringförmigen Speicherelementen, die auf dem GMR-Effekt beruhen, wurde in WO 96/25740 vorgeschlagen. Sie weisen Schichtelemente aus zwei magnetischen Materialien auf, von denen das eine eine hohe und das andere eine niedrige Koerzitivkraft aufweist. Zur Ansteuerung des magnetoresistiven Elementes sind zwei Treiberleitungen vorgesehen, die beide durch die Mitte des ringförmigen GMR-Elementes verlaufen. Das Umschalten der Magnetisierungsrichtung erfolgt mit Hilfe eines Magnetfeldes, das durch Ströme in den beiden Treiberleitungen induziert wird.

Zum Umschalten der Magnetisierungsrichtung fließt zwischen den beiden Leitungen, zwischen die das GMR-Element geschaltet ist, ein Strom, der auch über das Speicherelement fließt. Das von diesem Strom induzierte Magnetfeld wird zur Änderung der Magnetisierungsrichtung verwendet.

Da beide Treiberleitungen durch die Mitte des ringförmigen GMR-Elementes verlaufen und gegeneinander isoliert sein müssen, ist die in dieser Anordnung erzielbare Packungsdichte begrenzt.

Aus der US-A-5 541 868 ist eine Speicherzellenanordung mit magnetoresistiven Elementen entnehmbar bei der beiderseits der magnetoresistiven Elemente senkrechte Komponenten von sich kreuzenden Leitungen angeordnet sind.

Der Erfindung liegt das Problem zugrunde, eine Speicherzellenanordnung mit mindestens einem magnetoresistiven Element anzugeben, die gegen externe magnetische Störfelder unempfindlich ist, die sowohl für magnetoresistive Elemente mit TMR-Effekt als auch mit GMR-Effekt funktionsfähig ist und die mit im Vergleich zum Stand der Technik erhöhter Packungsdichte herstellbar ist. Ferner soll ein Verfahren zur Herstellung einer derartigen Speicherzellenanordnung angegeben werden.

Dieses Problem wird gelöst durch eine Speicherzellenanordnung gemäß Anspruch 1 sowie ein Verfahren zu deren Herstellung gemäß Anspruch 11. Weitere Ausgestaltungen der Erfindung gehen aus den übrigen Ansprüchen hervor.

Die Speicherzellenanordnung weist mindestens ein magnetoresistives Element auf, das einen in einer Schichtebene ringförmigen Querschnitt aufweist. Das magnetoresistive Element weist Schichtelemente auf, die senkrecht zur Schichtebene übereinander gestapelt sind. Durch die Verwendung eines magnetoresistiven Elementes mit ringförmigem Querschnitt wird eine erhöhte Unempfindlichkeit gegen externe magnetische Störfelder erzielt, da externe magnetische Störfelder über die Ausdehnung des ringförmigen Elementes sehr homogen und damit weitgehend wirkungslos sind. Auf zusätzliche Abschirmmaßnahmen zum Beispiel unter Verwendung von µ-Metall kann verzichtet werden.

Da in einem ringförmigen ferromagnetischen Schichtelement ein geschlossener Magnetfluß vorliegt, treten nach außen höchstens während des Ummagnetisierungsprozesses magnetische Streufelder auf. Schichtelemente eines oder benachbarter magnetoresistiver Elemente sind somit nahezu vollständig magnetisch entkoppelt. Daher können eine Vielzahl gleichartiger magnetoresistiver Elemente mit hoher Packungsdichte in der Speicherzellenanordnung vorgesehen werden.

In ringförmigen Schichtelementen existieren zwei stabile Magnetisierungszustände, das heißt der Magnetisierungsfluß ist entweder im Uhrzeigersinn oder entgegen dem Uhrzeigersinn geschlossen. Beide Zustände sind sehr stabil und die Übergänge von einem in den anderen Zustand sind unempfindlich gegen Defekte und geometrische Irregularitäten. Die Wahrscheinlichkeit von Informationsverlusten durch irreversible Magnetisierungsprozesse sind daher geringer als für konventionelle, einfach zusammenhängende Elementstrukturen.

Die Speicherzellenanordnung umfaßt darüber hinaus eine erste Leitung und eine zweite Leitung, die sich kreuzen. Im Kreuzungsbereich zwischen der ersten Leitung und der zweiten Leitung ist das magnetoresistive Element angeordnet. Dabei sind die erste Leitung und die zweite Leitung im Kreuzungsbereich bezüglich der Schichtebene auf unterschiedlichen Seiten des magnetoresistiven Elementes angeordnet. Die erste Leitung und/oder die zweite Leitung weisen mindestens einen ersten Leitungsanteil und einen zweiten Leitungsanteil auf. Der erste Leitungsanteil ist so ausgerichtet, daß darin eine zur Schichtebene parallel gerichtete Stromkomponente überwiegt, während in dem zweiten Leitungsanteil im Kreuzungsbereich zuwischen der ersten Leitung und der zweiten Leitung eine zur Schichtebene senkrecht gerichtete Stromkomponente überwiegt. Insbesondere verläuft der erste parallel zu der Schichtebene, der zweite Leitungsanteil kreuzt im Kreuzungsbereich zwischen der ersten Leitung und der zweiten Leitung eine zur Schichtebene parallele Ebene. Insbesondere sind die erste Leitung und/oder die zweite Leitung senkrecht zur Schichtebene gekröpft.

Die durch die derart gestalteten Leitungen fließenden Ströme erzeugen am Ort der ringförmigen magnetoresistiven Elemente ein Magnetfeld, das zum Ummagnetisieren der magnetoresistiven Elemente beim Schreibvorgang geeignet ist. Dabei tragen sowohl die in der Schichtebene azimutalen (zirkularen) Magnetfelder der vertikalen Stromkomponenten, als auch die lateralen, das heißt in der Schichtebene zur Längsrichtung der Leitung senkrecht gerichteten Magnetfeldkomponenten der parallelen Stromkomponenten zum Ummagnetisierungsfeld bei. Die zur Schichtebene parallelen Stromkomponenten tragen zur Ummagnetisierung bei, weil die ersten Leitungsanteile der ersten wie auch der zweiten Leitung unterschiedliche Abstände zum ringförmigen magnetoresistiven Element haben und sich daher dort nicht kompensieren.

Durch die derart gestalteten Leitungen sind Speicherzellenanordnungen möglich, die im Vergleich zu bisherigen Lösungen einfacher und mit größerer Packungsdichte hergestellt werden können. Die sich am Ort des Speicherelementes kreuzenden ersten und zweiten Leitungen sind zum Schreiben und Lesen ausreichend. Weitere Leitungen, zum Beispiel durch die ringförmigen Speicherelemente sind im Gegensatz zu der aus WO 96/25740 bekannten Lösung nicht erforderlich. Dadurch entsteht ein geringerer Flächenbedarf pro Speicherzelle.

Außerdem kann die Speicherzellenanordnung sowohl mit einem auf dem GMR-Effekt beruhenden magnetoresisitven Element als auch mit einem auf dem TMR-Effekt beruhenden magnetoresistiven Element realisiert werden, da im Gegensatz zu der aus US 5 477 482 und 5 541 868 bekannten Lösung zur Erzeugung des magnetischen Schaltfeldes kein Strom über das magnetoresistive Element erforderlich ist.

Vorzugsweise weist sowohl die erste Leitung als auch die zweite Leitung jeweils mindestens einen ersten Leitungsanteil, in dem eine zur Schichtebene parallel gerichtete Stromkomponente überwiegt, und einen zweiten Leitungsanteil, in dem eine zur Schichtebene senkrecht gerichtete Stromkomponente überwiegt, auf. Werden die erste Leitung und die zweite Leitung so beschaltet, daß der Strom durch den zweiten Leitungsanteil der ersten Leitung und der Strom durch den zweiten Leitungsanteil der zweiten Leitung in derselben Richtung fließen, so überlagern sich die azimutalen Magnetfelder dieser Ströme konstruktiv und verstärken sich am Ort des magnetoresistiven Elementes. Auf diese Weise ist selektives Schreiben in Speicherzellenfeldern möglich.

Wird das magnetoresistive Element zwischen die erste Leitung und die zweite Leitung geschaltet, so kann die gespeicherte Information über die erste Leitung und die zweite Leitung ausgelesen werden. Dazu wird der Widerstand des magnetoresistiven Elementes bewertet. Dies kann durch Messung des Absolutwiderstandes des magnetoresistiven Elementes, durch Messung der Widerstandsänderung beim Schalten des magnetoresistiven Elementes oder durch Widerstandsvergleich mit einem benachbarten magnetoresistiven.Elementes bekannten Magnetisierungszustandes erfolgen. Zum Auslesen der gespeicherten Information sind alle Verfahren zur Widerstandsbewertung des magnetoresistiven Elementes geeignet.

Das magnetoresistive Element weist vorzugsweise jeweils ein erstes ferromagnetisches Schichtelement, ein nichtmagnetisches Schichtelement und ein zweites ferromagnetisches Schichtelement auf, wobei das nichtmagnetische Schichtelement zwischen dem ersten ferromagnetischen Schichtelement und dem zweiten ferromagnetischen Schichtelement angeordnet ist. Das magnetoresistive Element kann sowohl auf dem GMR-Effekt als auch dem TMR-Effekt beruhen. Die Verwendung eines magnetoresistiven Elementes, das auf dem TMR-Effekt beruht wird wegen des im Vergleich zu einem GMR-Element größeren Widerstandes, des dadurch bedingten geringeren Leistungsverbrauchs und des meist größeren Magnetowiderstandseffektes bevorzugt. Darüber hinaus kann das magnetoresistive Element auf dem CMR-Effekt beruhen, falls die Anordnung die erforderlichen magnetischen Schaltfelder erzeugen kann.

Das erste ferromagnetische Schichtelement und das zweite ferromagnetische Schichtelement enthalten vorzugsweise mindestens eines der Elemente Fe, Ni, Co, Cr, Mn, Gd, Dy, Bi. Das erste ferromagnetische Schichtelement und das zweite ferromagnetische Schichtelement unterscheiden sich vorzugsweise bezüglich der magnetischen Härte und/oder ihrer Schichtdicke.

Senkrecht zur Schichtebene weisen das erste ferromagnetische Schichtelement und das zweite ferromagnetische Schichtelement vorzugsweise eine Dicke zwischen 2 nm und 20 nm auf. Das nichtmagnetische Schichtelement enthält im Fall des TMR-Effektes vorzugsweise mindestens eines der Materialien Al₂O₃, NiO, HfO₂, TiO₂, NbO, SiO₂ und weist senkrecht zur Schichtebene eine Dicke zwischen 1 und 4 nm auf. Im Fall eines GMR-Elementes enthält das nichtmagnetische Schichtelement vorzugsweise mindestens einen der Stoffe Cu, Au, Ag und/oder Al und weist senkrecht zur Schichtebene eine Dicke zwischen 2 und 5 nm auf. Das erste ferromagnetische Schichtelement, das zweite ferromagnetische Schichtelement und das nichtmagnetische Schichtelement weisen parallel zur Schichtebene vorzugsweise Abmessungen zwischen 50 nm und 400 nm auf.

Zur Speicherung großer Datenmengen weist die Speicherzellenanordnung eine Vielzahl gleichartiger magnetoresistiver Elemente auf, die matrixartig angeordnet sind. Ferner sind eine Vielzahl gleichartiger erster Leitungen und gleichartiger zweiter Leitungen vorgesehen. Die ersten Leitungen und die zweiten Leitungen kreuzen sich. Im Kreuzungsbereich zwischen einer der ersten Leitungen und einer der zweiten Leitungen ist jeweils eines der magnetoresistiven Elemente angeordnet. Die ersten Leitungen und/oder die zweiten Leitungen weisen jeweils alternierend erste Leitungsanteile, in denen eine parallel zur Schichtebene gerichtete Stromkomponente überwiegt, und zweite Leitungsanteile, in denen eine senkrecht zur Schichtebene gerichtete Stromkomponente überwiegt, auf. Da die ringförmigen magnetoresistiven Elemente magnetisch nahezu entkoppelt sind, kann dabei eine hohe Packungsdichte erzielt werden.

Vorzugsweise weisen sowohl die ersten Leitungen als auch die zweiten Leitungen jeweils erste Leitungsanteile und zweite Leitungsanteile auf, so daß ein selektives Schreiben in die einzelnen Speicherzellen möglich ist.

Gemäß einer Ausgestaltung der Erfindung sind die ersten Leitungsanteile und die zweiten Leitungsanteile einer der ersten Leitungen und/oder der zweiten Leitungen so angeordnet, daß die betreffende Leitung parallel zur Schichtebene einen streifenförmigen Querschnitt aufweist. In dieser Ausgestaltung kann ein Flächenbedarf pro Speicherzelle von 4 F² erzielt werden, wobei F die in der jeweiligen Technologie minimal herstellbare Strukturgröße ist, sofern die Breite der Leitungen parallel zur Schichtebene als auch der Abstand zwischen benachbarten Leitungen F beträgt. In dieser Anordnung entstehen in der Schichtebene am Ort jedes ringförmigen Speicherelementes durch konstruktive Überlagerung der von den vertikalen Stromkomponenten in den ersten und/oder zweiten Leitungen ein azimutales Magnetfeld, das für das Ummagnetisieren der ringförmigen magnetoresistiven Elemente primär verantwortlich ist. Magnetfeldbeiträge, die von den zur Schichtebene parallelen Stromkomponenten herrühren, führen zu einer Asymmetrie des resultierenden magnetischen Schaltfeldes, die sich hinsichtlich reduzierter Schaltfeldschwellen positiv auswirkt.

In einer weiteren Ausgestaltung der Speicherzellenanordnung sind die magnetoresistiven Elemente in Zeilen und Spalten zwischen den ersten und zweiten Leitungen angeordnet, wobei die Schichtebene durch die Mittelebenen der magnetoresistiven Elemente aufgespannt wird. Dabei verlaufen die Richtung der Zeilen und die Richtung der Spalten parallel zur Schichtebene, wobei sich die Richtung der Zeilen mit der Richtung der Spalten kreuzt. Die Projektionen der ersten Leitungsanteile einer der ersten Leitungen auf die Schichtebene sind jeweils zwischen benachbarten magnetoresistiven Elementen dieser Zeile so angeordnet, daß die Projektionen bezüglich der Verbindungsgeraden durch die magnetoresitiven Elemente dieser Zelle seitlich alternierend versetzt angeordnet sind. Die Projektion der ersten Leitungsanteile einer der zweiten Leitungen auf die Schichtebene ist jeweils zwischen benachbarten magnetoresistiven Elementen einer der Spalten angeordnet, wobei die Projektion bezüglich einer Verbindungslinie zwischen den benachbarten magnetoresistiven Elementen seitlich versetzt angeordnet ist. Die Projektionen von entlang einer der Leitungen benachbarten ersten Leitungsanteilen auf die Schichtebene ist bezüglich der jeweiligen Verbindungslinien nach entgegengesetzten Seiten versetzt angeordnet. Die Projektionen der ersten Leitungen und der zweiten Leitungen auf die Schichtebene sind somit keine langgestreckten Rechtecke, sondern wellenförmig. In dieser Ausgestaltung werden am Ort der magnetoresistiven Elemente zweizählig symmetrische lokale azimutale Magnetfelder verursacht. Der Platzbedarf pro Speicherzelle beträgt 9 F².

In dieser Ausgestaltung der Speicherzellenanordnung werden magnetische Schaltfelder höherer, nämlich zweizähliger Symmetrie in der Schichtebene am Ort der ringförmigen Elemente erzeugt. Diese Ausgestaltung weist vorzugsweise folgende Merkmale auf:
- Die Projektion der ersten und zweiten Leitungen auf die Schichtebene sind Bänder, deren Mittellinien und Ränder wellenartige, zueinander parallele Polygonzüge sind.
- Die Strukturen in den wellenartigen Bändern wiederholen sich periodisch, wobei die wellenartigen Bänder um eine mittlere Längsrichtung schwingen.
- Die benachbarten Projektionsbänder der ersten und zweiten Leitungen sind gegeneinander um eine halbe Periode in Längsrichtung verschoben.
- Die Projektionsbänder der ersten Leitungen kreuzen sich mit denen der zweiten Leitungen in den "Nullstellen" der Wellenbänder, wobei die mittleren Längsrichtungen einen rechten Winkel bilden, die Bänder abschnittsweise aber parallel zueinander verlaufen. Als Nullstelle wird dabei jeweils der Kreuzungspunkt des Projektionsbandes mit der jeweiligen mittleren Längsrichtung bezeichnet.
- Die ringförmigen magnetoresistiven Elemente sind in der Schichtebene an den Kreuzungsstellen zwischen den ersten und zweiten Leitungen in Zeilen und Spalten angeordnet.
- Die ersten und zweiten Leitungen sind an den Kreuzungsstellen senkrecht zur Schichtebene gekröpft, so daß an diesen Stellen zweite Leitungsanteile mit senkrechten Stromkomponenten existieren.

Bei konstruktiver Überlagerung der von den vertikalen Stromkomponenten der ersten und zweiten Leitungen erzeugten Magnetfelder und ausreichender Stromstärke lassen sich mit dieser Anordnung zweizählig symmetrische Schaltfelder am Ort der ringförmigen magnetoresistiven Elemente erzeugen.

Diese Ausgestaltung läßt sich mit einem Platzbedarf pro Speicherzelle von 9F² realisieren. Dazu weist die Speicherzellenanordnung zusätzlich folgende Merkmale Merkmale auf:
- Die Periode der wellenartigen Bänder beträgt 6F, ihre Amplitude F/2.
- Die Bänder haben senkrecht zu ihrer Längsrichtung eine minimale Breite und einen minimalen Abstand F.
- Die Projektionsbänder der ersten Leitungen und der zweiten Leitungen verlaufen in Segmenten der Länge F parallel zueinander.
- Die ringförmigen Speicherelemente sind in der Schichtebene an den Kreuzungsstellen zwischen den ersten und zweiten Leitungen in Abständen von 3F in Zeilen und Spalten angeordnet.

Zur Herstellung der Speicherzellenanordnung wird auf einer Hauptfläche eines Substrats eine erste Leitung erzeugt. Durch Abscheiden und Strukturieren einer ersten ferromagnetischen Schicht, einer nichtmagnetischen Schicht und einer zweiten ferromagnetischen Schicht wird das magnetoresistive Element gebildet, das in einer Schichtebene einen ringförmigen Querschnitt aufweist. Es wird eine zweite Leitung erzeugt, die die erste Leitung so kreuzt, daß das magnetoresistive Element im Kreuzungsbereich angeordnet ist. Die erste Leitung und/oder die zweite Leitung werden so erzeugt, daß sie mindestens einen ersten Leitungsanteil, in dem eine parallel zur Schichtebene gerichtete Stromkomponenete überwiegt, und einen zweiten Leitungsanteil, in dem eine senkrecht zur Schichtebene gerichtete Stromkomponente überwiegt, aufweisen.

Die Strukturierung der ersten ferromagnetischen Schicht, der nichtmagnetischen Schicht und der zweiten ferromagnetischen Schicht erfolgt vorzugsweise mit ein und derselben Maske.

Zur Strukturierung des ringförmigen, magnetoresistiven Elementes ist es vorteilhaft, einen selbstjustierten Prozeß zu verwenden. Zu diesem Zweck wird in einer Schicht, die an einer Hauptfläche eines Substrats angeordnet ist, eine Öffnung erzeugt, über deren Flanken eine konforme Schicht abgeschieden wird. Durch anisotropes Rückätzen der konformen Schicht entsteht an den Flanken ein ringförmiger Spacer, der als Maske für die anisotrope Strukturierung verwendet wird. Wird die Öffnung mit einer Abmessung von F erzeugt, so lassen sich auf diese Weise magnetoresistive Elemente mit einem Außendurchmesser von F und einem Innendurchmesser kleiner F herstellen.

Vorzugsweise werden die erste Leitung und die zweite Leitung jeweils in zwei Schritten hergestellt. Dabei werden zunächst untere Segmente der ersten Leitung bzw. der zweiten Leitung gebildet und danach obere Segmente der ersten Leitung bzw. der zweiten Leitung. Die Projektion der unteren Segmente und die Projektion der oberen Segmente der jeweiligen Leitung auf die Hauptfläche des Substrats überlappen sich teilweise, so daß zusammenhängende und gekröpfte erste und zweite Leitungen entstehen. Die zweiten Leitungsanteile, in denen zur Schichtebene vertikale Stromkomponenten auftreten, entstehen in den Überlappungsbereichen der unteren und oberen Segmente der jeweiligen Leitung. Dazwischen angeordnete Teile der unteren Segmente bzw. der oberen Segmente stellen die ersten Leitungsanteile, die parallel zur Schichtebene verlaufen, dar.

Bei der Herstellung der unteren Segmente der ersten Leitung bzw. der zweiten Leitung wird gleichzeitig in der Peripherie der Speicherzellenanordnung eine erste Metallisierungsebene, die in der Fachwelt meist als Metall 1 bezeichnet wird, bzw. eine zweite Metallisierungsebene, die in der Fachwelt meist als Metall 2 bezeichnet wird, gebildet. Bei der Herstellung der oberen Segmente der ersten Leitung bzw. der zweiten Leitung werden gleichzeitig in der Peripherie erste Kontakte, die in der Fachwelt als Via 1 bezeichnet werden, bzw. zweite Kontakte, die in der Fachwelt meist als Via 2 bezeichnet werden, gebildet.

Vorzugsweise werden die ersten Leitungen des Zellenfeldes über die erste Metallisierungsebene und die zweiten Leitungen des Zellenfeldes über die zweite Metallisierungsebene der Peripherie kontaktiert.

Die Herstellung der ersten Leitung und der zweiten Leitung erfolgt vorzugsweise mit Hilfe der Damascene-Technik. Dazu wird eine erste isolierende Schicht abgeschieden und mit Hilfe photolithographischer Prozeßschritte und anisotroper Plasmaätzschritte (RIE) so strukturiert, daß sie im Bereich der nachfolgend herzustellenden ersten Metallisierungsebene der Peripherie und der unteren Segmente der ersten Leitungen des Zellenfeldes entfernt wird. Es wird eine erste leitende Schicht oder ein erstes leitendes Schichtsystem abgeschieden und durch ein planarisierendes Ätzverfahren, zum Beispiel CMP, strukturiert. Dadurch werden die unteren Segmente der ersten Leitungen und die erste Metallisierungsebene der Peripherie gebildet. Nachfolgend wird eine zweite isolierende Schicht abgeschieden und mit Hilfe photolithographischer Prozeßschritte und anisotroper Ätzschritte so strukturiert, daß sie im Bereich der nachfolgend herzustellenden ersten Kontakte der Peripherie und der oberen Segmente der ersten Leitung entfernt wird. Die ersten Kontakte und die oberen Segmente der ersten Leitung werden durch Abscheiden einer zweiten leitenden Schicht oder eines zweiten leitenden Schichtsystems und deren Strukturierung durch ein planarisierendes Ätzverfahren, zum Beispiel CMP, gebildet.

Entsprechend werden die unteren Segmente der zweiten Leitung und die zweite Metallisierungsebene der Peripherie durch Abscheidung und Strukturierung einer dritten isolierenden Schicht und einer dritten leitenden Schicht oder eines dritten leitenden Schichtsystems und die oberen Segmente der zweiten Leitung und die zweiten Kontakte der Peripherie durch Abscheidung und Strukturierung einer vierten isolierenden Schicht und einer vierten leitenden Schicht gebildet.

Durch die Herstellung der ersten Leitung und der zweiten Leitung jeweils in zwei Schritten kann die Herstellung der Speicherzellenanordnung auf einfache Weise in einen Mehrlagenverdrahtungsprozeß integriert werden. Zur Bildung der unteren und oberen Segmente der ersten bzw. zweiten Leitung werden Abscheideschritte und Strukturierungsschritte verwendet, die für die Herstellung der peripheren Metallisierungsebenen sowie der dazwischen erforderlichen Kontakte, auch Via genannt, erforderlich sind. Die Bildung der unteren bzw, oberen Segmente der ersten Leitungen des Zellenfeldes erfolgt im selben Arbeitsgang wie die Bildung der ersten Metallisierungsebene (Metall 1) bzw. der ersten Kontakt-Ebene (Via 1) der Peripherie. Desgleichen werden die unteren bzw. oberen Segmente der zweiten Leitungen gleichzeitig mit der zweiten Metallisierungsebene (Metall 2) bzw. der zweiten Kontakt-Ebene (Via 2) gebildet.

Durch diese Vorgehensweise wird außerdem das technische Problem gelöst, daß zwischen übereinander angeordneten Metallisierungsebenen der Peripherie ein sehr viel größerer vertikaler Abstand als zwischen den ersten und den zweiten Leitungen des Zellenfeldes vorhanden ist. Der vertikale Abstand zwischen den ersten und zweiten Leitungen im Zellenfeld wird von den Abmessungen des magnetoresistiven Elementes bestimmt, die typischerweise 20 bis 40 nm betragen. Der Abstand zwischen benachbarten Metallisierungsebenen der Peripherie muß zur Reduzierung parasitärer Kapazitäten wesentlich größer sein. Bei einer 0,35 µm Technologie beträgt er typischerweise 350 bis 400 nm. Durch das beschriebene Vorgehen wird dieses Problem gelöst, ohne daß zusätzliche Metallisierungsebenen, zusätzliche Topographie oder Vias mit großen Aspektverhältnissen entstehen.

Im folgenden wird die Erfindung anhand von Ausführungsbeispielen, die in den Figuren dargestellt sind, näher erläutert.
- Figur 1: zeigt einen Schnitt durch eine Speicherzellenanordnung mit ringförmigen magnetoresistiven Elementen und ersten Leitung und zweiten Leitungen, die jeweils erste Leitungsanteile, die parallel zur Schichtebene verlaufen, und jeweils zweite Leitungsanteile, die senkrecht zur Schichtebene verlaufen, aufweisen.
- Figur 2: zeigt den in Figur 1 mit II-II bezeichneten Schnitt.
- Figur 3: zeigt eine Aufsicht auf eine Speicherzellenanordnung mit magnetoresistiven ringförmigen Elementen und ersten Leitungen und zweiten Leitungen, deren Projektionen auf die Schichtebene streifenförmige Bänder sind.
- Figur 4: zeigt eine Aufsicht auf eine Speicherzellenanordnung mit ringförmigen magnetoresistiven Elementen und ersten Leitungen und zweiten Leitungen, deren Projektionen auf die Schichtebene wellenförmige, polygonzugartige Bänder sind.
- Figur 5: zeigt den in Figur 4 mit V-V bezeichneten Schnitt durch ein magnetoresistives Element und die benachbarten Bereiche der zugehörigen ersten Leitung und der zugehörigen zweiten Leitung.
- Figur 6: zeigt einen Schnitt durch ein Substrat mit einer ersten SiO₂-Schicht, einer ersten Si₃N₄-Schicht und einer zweiten SiO₂-Schicht.
- Figur 7: zeigt den Schnitt durch das Substrat nach Bildung unterer Segmente erster Leitungen des Zellenfeldes und einer ersten Metallisierungsebene der Peripherie.
- Figur 8: zeigt das Substrat nach Abscheidung und Strukturierung einer zweiten Si₃N₄-Schicht und einer dritten SiO₂-Schicht.
- Figur 9: zeigt das Substrat nach Bildung erster Kontakte der Peripherie und oberer Segmente der ersten Leitungen im Zellenfeld.
- Figur 10: zeigt das Substrat nach Abscheidung einer ersten leitenden Barriereschicht, einer ersten ferromagnetischen Schicht, einer nichtmagnetischen Schicht, einer zweiten ferromagnetischen Schicht und einer zweiten leitenden Barriereschicht.
- Figur 11: zeigt das Substrat nach Bildung von magnetoresistiven Elementen durch Strukturierung der zuvor abgeschiedenen Schichten unter Anwendung eines selbstjustierten, auf Spacerbildung basierenden Verfahrens, das anhand von Figur 20 bis 22 erläutert wird.
- Figur 12: zeigt das Substrat nach Bildung einer planarisierenden isolierenden Schicht.
- Figur 13: zeigt das Substrat nach Abscheidung und Strukturierung einer dritten Si₃N₄-Schicht und einer vierten SiO₂-Schicht.
- Figur 14: zeigt das Substrat nach Strukturierung der vierten SiO₂-Schicht und der planarisierenden isolierenden Schicht.
- Figur 15: zeigt das Substrat nach Bildung unterer Segmente von zweiten Leitungen im Zellenfeld und einer zweiten Metallisierungsebene in der Peripherie.
- Figur 16: zeigt das Substrat nach Abscheidung und Strukturierung einer vierten Si₃N₄-Schicht und einer fünften SiO₂-Schicht.
- Figur 17: zeigt das Substrat nach Bildung oberer Segmente der zweiten Leitungen im Zellenfeld und zweiter Kontakte der Peripherie.
- Figur 18: zeigt das Substrat nach Abscheidung und Strukturierung einer fünften Si₃N₄-Schicht und einer sechsten SiO₂-Schicht.
- Figur 19: zeigt das Substrat nach Bildung einer dritten Metallisierungsebene.
- Figur 20: zeigt einen Schnitt durch ein Substrat mit einem oberen Segment der ersten Leitung nach Abscheidung einer ersten ferromagnetischen Schicht, einer nichtmagnetischen Schicht und einer zweiten ferromagnetischen Schicht, nach Abscheidung und Strukturierung einer Hilfsschicht und nach Abscheidung einer konformen Schicht.
- Figur 21: zeigt den Schnitt durch das Substrat nach anisotropem Ätzen der konformen Schicht, wodurch eine spacerförmige Maske gebildet wird.
- Figur 22: zeigt das Substrat nach Entfernen der strukturierten Hilfsschicht und nach Bildung magnetoresistiver Elemente durch Strukturierung der ersten ferromagnetischen Schicht, der nichtmagnetischen Schicht und der zweiten ferromagnetischen Schicht.
- Figur 23: zeigt ein magnetoresistives Element mit ringförmigen Schichtelementen.

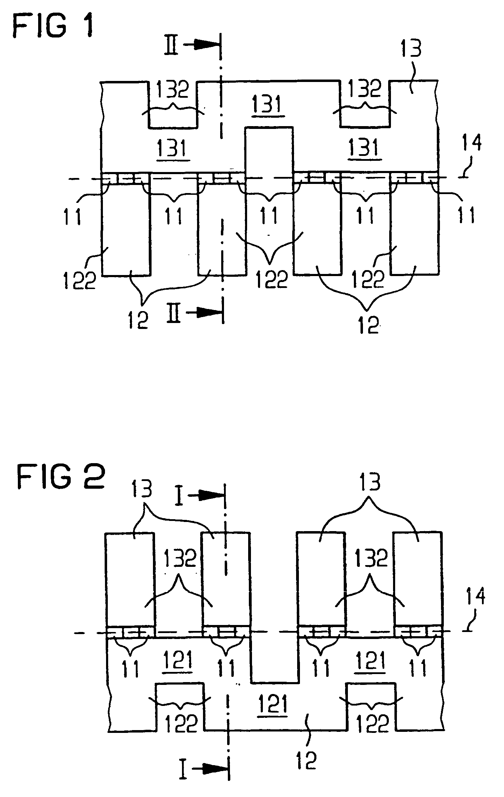

In einer Speicherzellenanordnung sind ringförmige magnetoresistive Elemente 11 jeweils zwischen einer ersten Leitung 12 und einer zweiten Leitung 13 angeordnet (siehe Figur 1 und Figur 2). Die magnetoresistiven Elemente weisen in einer Schichtebene 14, die senkrecht zur Zeichenebene verläuft, einen ringförmigen Querschnitt auf. Die ersten Leitungen 12 weisen erste Leitungsanteile 121 und zweite Leitungsanteile 122 auf. Die ersten Leitungsanteile 121 verlaufen parallel zu der Schichtebene 14, die zweiten Leitungsanteile 122 dagegen senkrecht zur Schichtebene 14. Entsprechend weisen die zweiten Leitungen 13 erste Leitungsanteile 131 und zweite Leitungsanteile 132 auf. Die ersten Leitungsanteile 131 verlaufen parallel zur Schichtebene 14, die zweiten Leitungsanteile 132 vertikal zur Schichtebene 14. Fließt ein Strom durch die erste Leitung 12 bzw. durch die zweite Leitung 13, so überwiegt in den ersten Leitungsanteilen 121 bzw. 131 eine parallel zu der Schichtebene 14 gerichtete Stromkomponente. In den zweiten Leitungsanteilen 122 bzw. 132 überwiegt dagegen eine senkrecht zu der Schichtebene 14 gerichtete Stromkomponente.

Fließt ein Strom durch die erste Leitung 12, so bewirken durch die zweiten Leitungsanteile 122 fließende, vertikale Stromkomponenten am Ort der magnetoresistiven Elemente 11 ein azimutales Magnetfeld. Entsprechend bewirken in der zweiten Leitung 13 durch die zweiten Leitungsanteile 132 fließende vertikale Stromkomponenten ein azimutales Magnetfeld am Ort der magnetoresistiven Elemente 11. Werden die ersten Leitungen und die zweiten Leitungen 13 so gepolt, daß am Ort des im Kreuzungsbereich zwischen einer der ersten Leitungen 12 und einer der zweiten Leitungen 13 angeordneten magnetoresistiven Elementes 11 die vertikalen Stromkomponenten in dem jeweiligen zweiten Leitungsanteil 122, 132 in derselben Richtung fließen, so kommt es zu einer konstruktiven Überlagerung dieser azimutalen Magnetfelder und die Magnetisierung des in diesem Kreuzungsbereich angeordneten magnetoresistiven Elementes 11 kann umgeschaltet werden.

Das Vorsehen der ersten Leitungsanteile 121, 131 und der zweiten Leitungsanteile 122, 132 führt dazu, daß die ersten Leitungen 12 bzw. die zweiten Leitungen 13 in einer Ebene senkrecht zu der Schichtebene 14 einen stufenförmigen Querschnitt aufweisen.

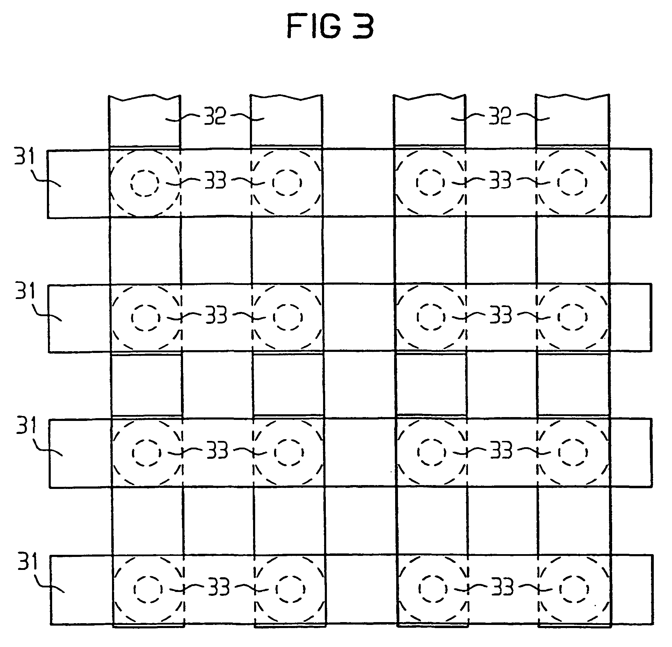

Eine Speicherzellenanordnung weist erste Leitungen 31 auf, die untereinander parallel verlaufen, und zweite Leitungen 32, die untereinander ebenfalls parallel verlaufen und die die ersten Leitungen 31 kreuzen (siehe Figur 3). In der Aufsicht weisen die ersten Leitungen 31 und die zweiten Leitungen 32 jeweils einen streifenförmigen Querschnitt auf. Sie weisen eine Breite von 0,35 µm, einen gegenseitigen Abstand von 0,35 µm und eine von der Zellenfeldgröße abhängige Länge von ca. 70 bis 700 µm auf.

Im Kreuzungsbereich zwischen einer der ersten Leitungen 31 und einer der zweiten Leitungen 32 ist jeweils ein magnetoresistives Element 33 mit einem ringförmigen Querschnitt angeordnet. Da es in der Aufsicht in Figur 3 von der zweiten Leitung 32 jeweils verdeckt ist, ist in Figur 3 die Kontur des magnetoresistiven Elementes 33 jeweils gestrichelt eingezeichnet.

Die ersten Leitungen 31 sowie die zweiten Leitungen 32 weisen in einem Schnitt senkrecht zur Zeichenebene und parallel zum streifenförmigen Verlauf einen stufenförmigen Querschnitt mit ersten Leitungsanteilen, die parallel zur Zeichenebene verlaufen, und zweiten Leitungsanteilen, die senkrecht zur Zeichenebene verlaufen, auf, wie anhand von Figur 1 und 2 beschrieben. Fließt ein Strom durch die erste Leitung 31 bzw. durch die zweite Leitung 32, so überwiegt in den ersten Leitungsanteilen jeweils eine parallel zu dem ringförmigen Querschnitt gerichtete Stromkomponente. In den zweiten Leitungsanteilen überwiegt dagegen eine senkrecht zu dem ringförmigen Querschnitt gerichtete Stromkomponente. Oberhalb und unterhalb jedes der magnetoresistiven Elemente 33 ist ein zweiter Leitungsanteil der zugehörigen ersten Leitung 31 und der zugehörigen zweiten Leitung 32 angeordnet, in dem ein Strom senkrecht zu dem ringförmigen Querschnitt des magnetoresistiven Elementes 33 fließen kann.

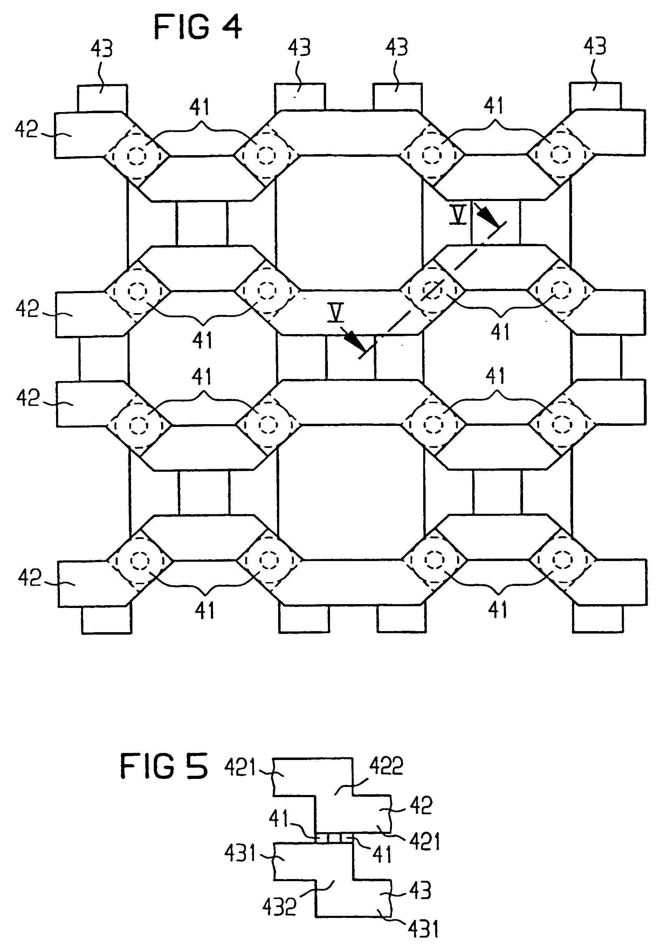

In einer Speicherzellenanordnung sind ringförmige magnetoresistive Elemente 41 in einer Ebene, die als Schichtebene bezeichnet wird, rasterförmig in Zeilen und Spalten angeordnet (siehe Figur 4).

Jedes der magnetoresistiven Elemente 41 ist zwischen einer ersten Leitung 42 und einer zweiten Leitung 43 angeordnet. Die Projektion der ersten Leitungen 42 und der zweiten Leitungen 43 auf die Schichtebene sind jeweils wellenförmige, polygonzugartige Bänder, die zu der jeweiligen Zeile bzw. Spalte parallele Anteile enthalten. Diese parallelen Anteile sind bezüglich der Geraden durch die Mittelpunkte benachbarter magnetoresistiver Elemente 41 alternierend parallel versetzt angeordnet.

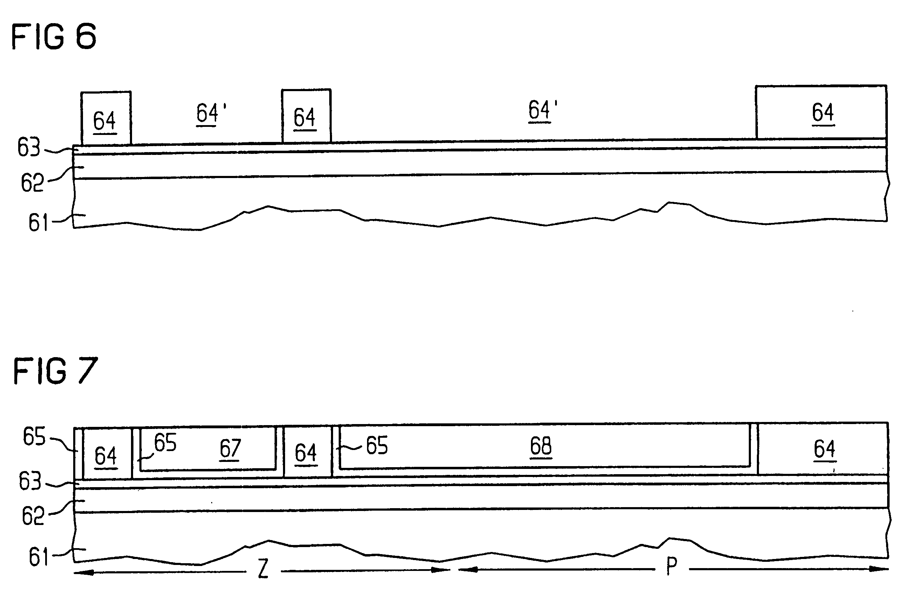

Senkrecht zu der Zeichenebene weisen die ersten Leitungen 42 und die zweiten Leitungen 43 einen stufenförmigen Querschnitt auf (siehe Figur 5, in der der in Figur 4 mit V-V bezeichnete Schnitt dargestellt ist). Die erste Leitung 42 weist einen ersten Leitungsanteil 421 und einen zweiten Leitungsanteil 422 auf. Der erste Leitungsanteil 421 verläuft parallel zur Zeichenebene, der zweite Leitungsanteil 422 verläuft dagegen senkrecht zur Zeichenebene.

Die zweite Leitung 43 weist einen ersten Leitungsanteil 431 auf, der parallel zur Zeichenebene verläuft. Die zweite Leitung 43 weist darüber hinaus einen zweiten Leitungsanteil 432 auf, der senkrecht zur Zeichenebene verläuft.

Entlang jeder der ersten Leitungen 42 und der zweiten Leitungen 43 sind alternierende erste Leitungsanteile 421, 431 und zweite Leitungsanteile 422, 432 angeordnet.

Auf ein Substrat 61 aus monokristallinem Silizium, das Bauelemente wie MOS-Transistoren und dergleichen enthält, werden eine erste SiO₂-Schicht 62 in einer Schichtdicke von 50 bis 100 nm, eine erste Si₃N₄-Schicht 63 in einer Schichtdicke von 30 bis 50 nm und eine zweite SiO₂-Schicht 64 in einer Schichtdicke von 400 bis 800 nm aufgebracht (siehe Figur 6). Unter Verwendung einer photolithographisch erzeugten Lackmaske und anisotropem Ätzen wird die zweite SiO₂-Schicht 64 so strukturiert, daß in der zweiten SiO₂-Schicht 64 Gräben 64' geöffnet werden.

Nachfolgend werden ganzflächig eine erste leitende Diffusionsbarriereschicht 65 aus TaN/Ta in einer Dicke von 50 nm und eine erste leitende Schicht aus Kupfer abgeschieden. Die erste leitende Schicht aus Kupfer wird in einer solchen Dicke abgeschieden, daß sie die Gräben 64' vollständig auffüllt. Die erste leitende Diffusionsbarriereschicht 65 und die erste leitende Schicht werden durch chemisch mechanisches Polieren strukturiert. Dabei werden die Oberfläche der zweiten SiO₂-Schicht 64 freigelegt und die in die Gräben 64' eingebetteten unteren Segmente 67 einer ersten Leitung im Bereich eines Zellenfeldes Z und Leitungen einer ersten Metallisierungsebene 68 im Bereich einer Peripherie P erzeugt (siehe Figur 7).

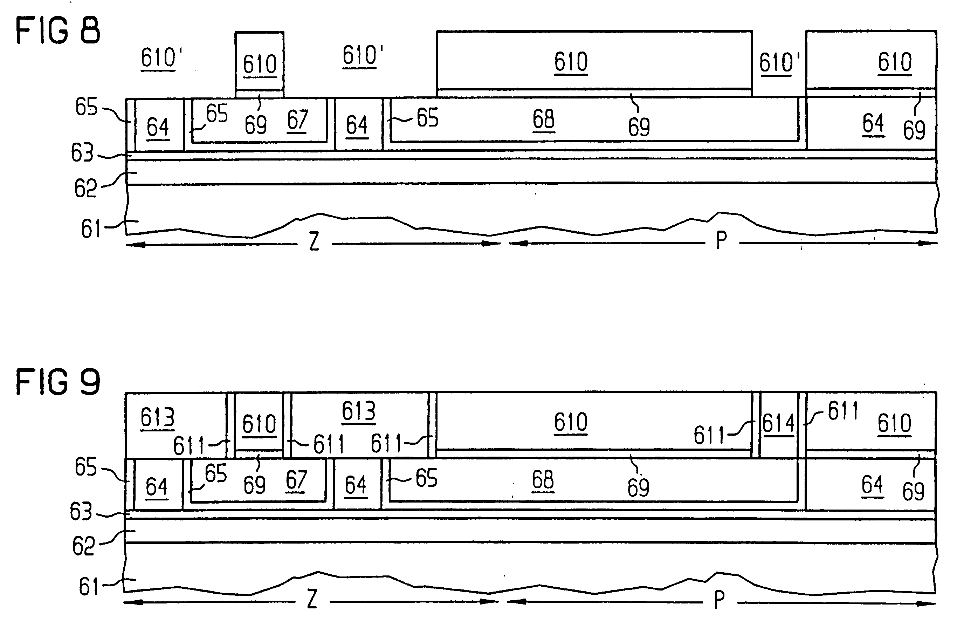

Nachfolgend werden eine zweite Si₃N₄-Schicht 69 in einer Dikke von 30 bis 50 nm und eine dritte SiO₂-Schicht 610 in einer Dicke von 400 bis 800 nm abgeschieden und mit Hilfe einer photolithographisch erzeugten Lackmaske und anisotropem Ätzen strukturiert (siehe Figur 8). Dabei werden Gräben 610' gebildet.

Anschließend werden ganzflächig eine zweite leitende Barriereschicht 611 und eine zweite leitende Schicht 612 abgeschieden. Die zweite leitende Barriereschicht 611 wird in einer Schichtdicke von 50 nm aus TaN/Ta gebildet. Die zweite leitende Schicht wird aus Kupfer in einer solchen Schichtdicke abgeschieden, daß sie die Gräben 610' auffüllt. Durch CMP werden die zweite leitende Schicht und die zweite leitende Barriereschicht 611 planarisiert, so daß die Oberfläche der dritten SiO₂-Schicht 610 freigelegt wird und in die Gräben 610' eingebettete obere Segmente der ersten Leitung 613 und erste Kontakte 614 erzeugt werden (siehe Figur 9). Die oberen Segmente 613 der ersten Leitung und die unteren Segmente 67 der ersten Leitung überlappen sich teilweise.

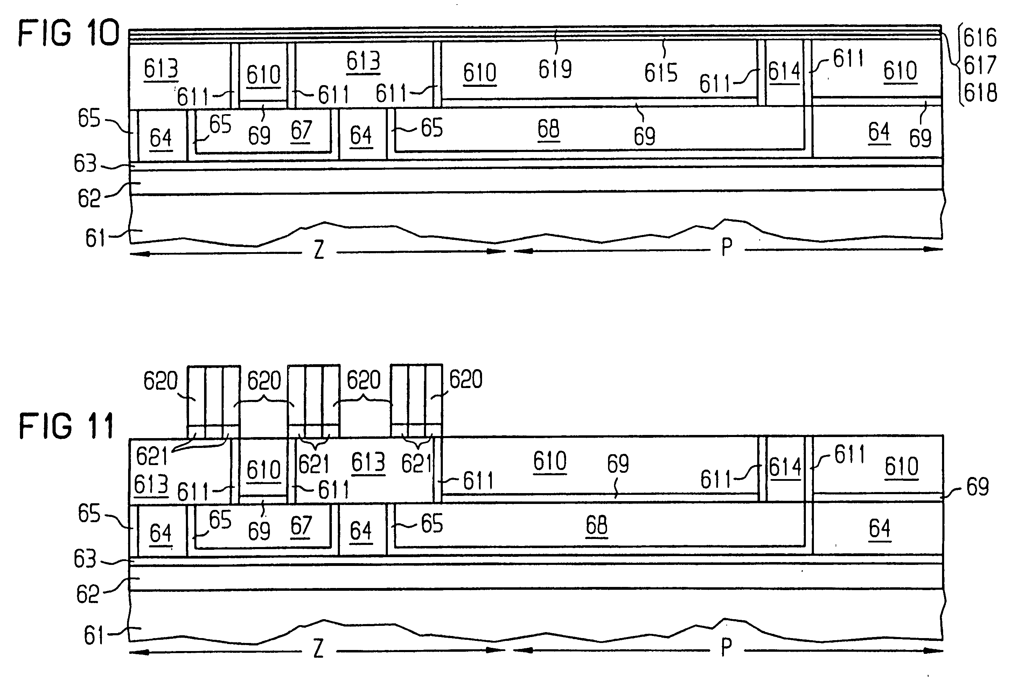

Anschließend wird ganzflächig eine erste Barriereschicht 615, eine erste ferromagnetische Schicht 616, eine nichtmagnetische Schicht 617, eine zweite ferromagnetische Schicht 618 und eine zweite Diffusionsbarriereschicht 619 abgeschieden (siehe Figur 10). Die erste Diffusionsbarriereschicht 615 und die zweite Diffusionsbarriereschicht 619 werden in einer Schichtdicke von 10 bis 30 nm aus Ta gebildet. Die erste ferromagnetische Schicht 616 wird in einer Schichtdicke von 3 bis 10 nm aus Co gebildet. Die nichtmagnetische Schicht 617 wird in einer Schichtdicke von 1 bis 3 nm aus Al₂O₃ gebildet. Die zweite ferromagnetische Schicht 618 wird in einer Schichtdicke von 3 bis 10 nm aus NiFe gebildet. In Figur 10 sind der Überlichtlichkeit halber die erste ferromagnetische Schicht 616, die nichtmagnetische Schicht 617 und die zweite ferromagnetische Schicht 618 als Dreifachschicht 616, 617, 618 dargestellt.

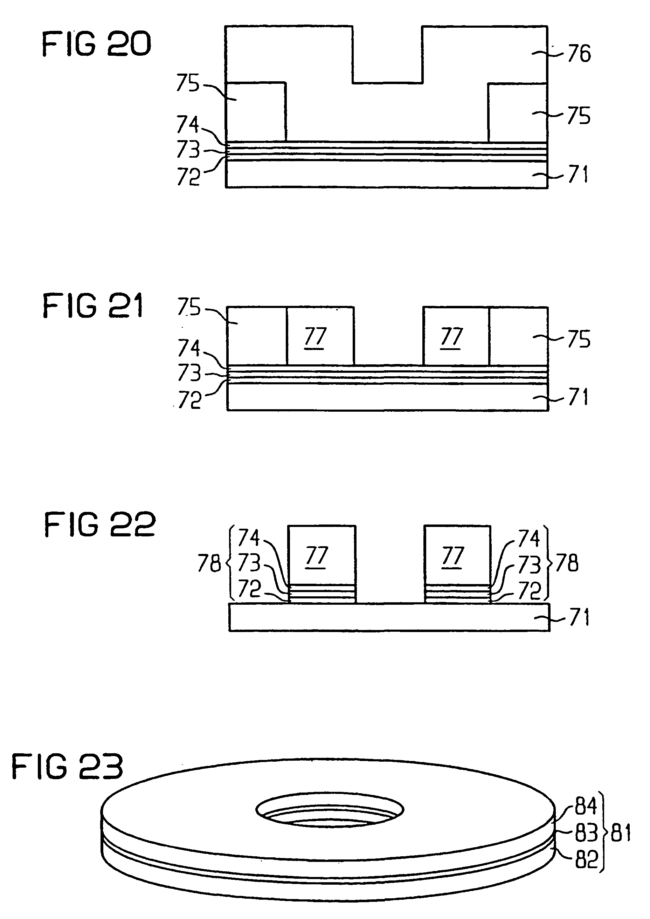

Unter Verwendung einer Maske 620 werden durch anisotropes Atzen der ersten Diffusionsbarriereschicht 615, der ersten ferromagnetischen Schicht 616, der nichtmagnetischen Schicht 617, der zweiten ferromagnetischen Schicht 618 und der zweiten Diffusionsbarriereschicht 619 magnetoresistive Elemente 621 gebildet, die parallel zur Oberfläche des Substrats 61 einen ringförmigen Querschnitt aufweisen (siehe Figur 11). Die Maske 620 wird mit einem selbstjustierten Prozeß erzeugt, der anhand der Figuren 20 bis 22 weiter unten erläutert.

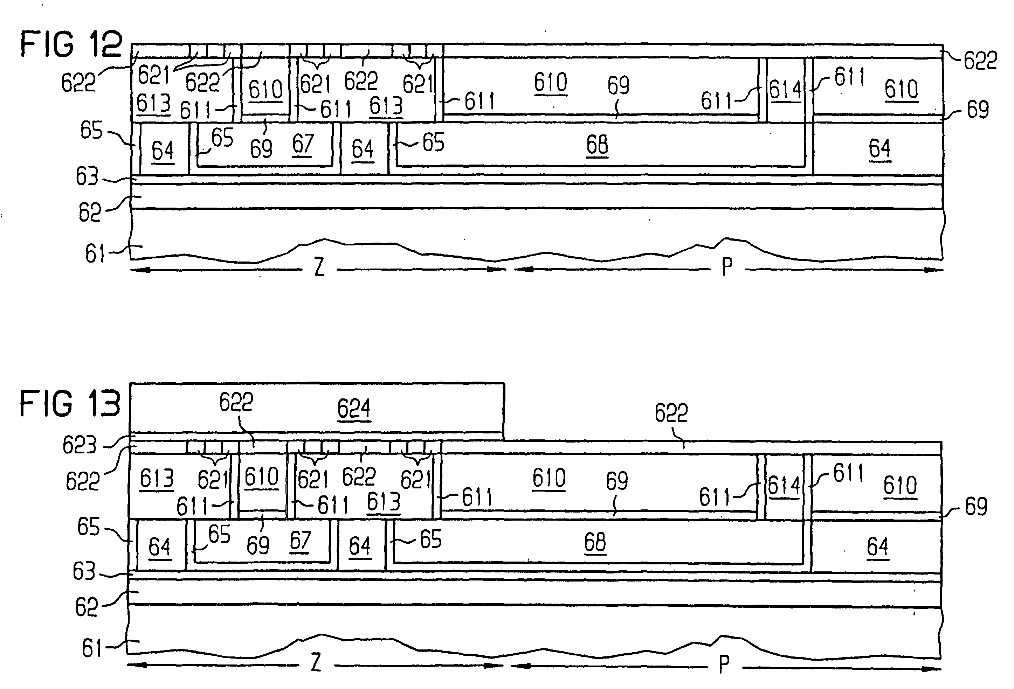

Durch Abscheidung und Planarisierung mit CMP einer vierten SiO₂-Schicht 622 werden die magnetoresistiven Elemente 621 mit isolierendem Material umgeben (siehe Figur 12).

Nachfolgend wird eine dritte Si₃N₄-Schicht 623 abgeschieden und unter Verwendung einer Photolackmaske 624 so strukturiert, daß die magnetoresistiven Elemente 621 von der dritten Si₃N₄-Schicht 623 bedeckt bleiben, während diese Schicht im Bereich der Peripherie entfernt wird (siehe Figur 13).

Nach Entfernen der Photolackmaske 624 wird ganzflächig eine fünfte SiO₂-Schicht 625 in einer Dicke von 400 bis 800 nm abgeschieden, an deren Oberfläche durch photolithographische Prozeßschritte eine Photolackmaske 626 gebildet wird.

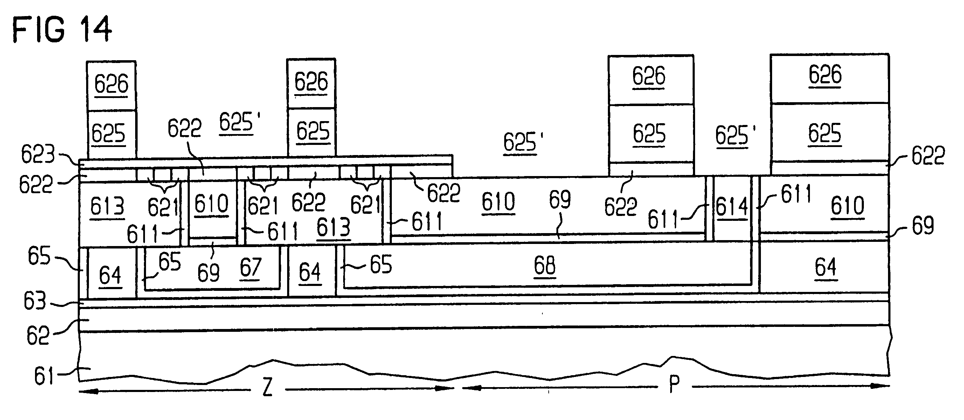

Unter Verwendung der Photolackmaske 626 als Ätzmaske werden die fünfte SiO₂-Schicht 625 und die vierte SiO₂-Schicht 622 strukturiert. Dabei werden Gräben 625' erzeugt (siehe Figur 14). Oberhalb der magnetoresistiven Elemente 621 verbleibt die dritte Si₃N₄-Schicht 623.

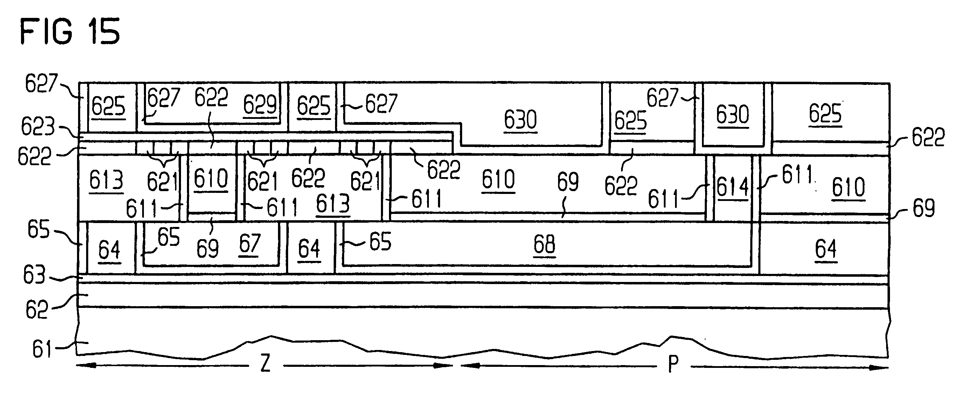

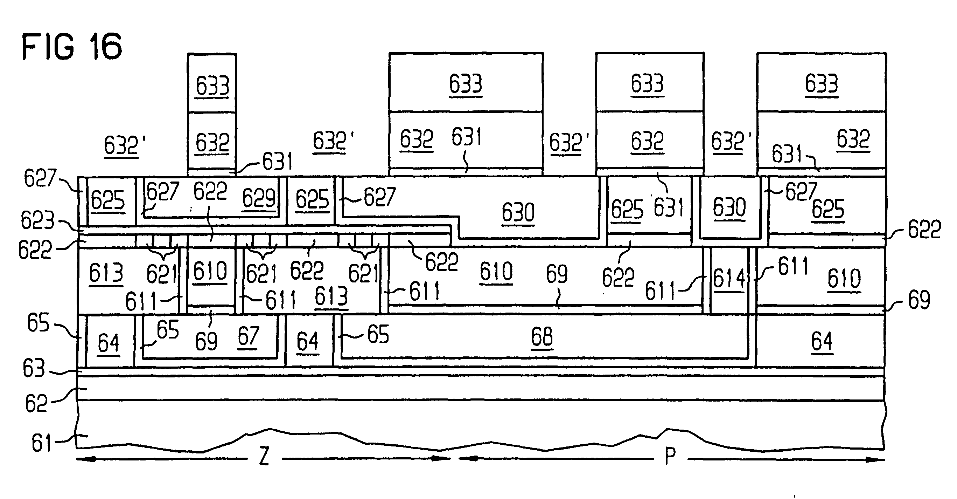

Nach Entfernen der Maske 626 wird eine dritte leitende Barriereschicht 627 und eine dritte leitende Schicht abgeschieden, die die Gräben 625' auffüllen (siehe Figur 15). Die dritte leitende Barriereschicht 627 wird in einer Schichtdikke von 30 bis 50 nm aus Ta/TaN gebildet. Die dritte leitende Schicht wird aus Kupfer gebildet. Durch chemisch mechanisches Polieren werden die dritte leitende Barriereschicht 627 und die dritte leitende Schicht planarisiert. Dabei wird die Oberfläche der fünften SiO₂-Schicht 625 freigelegt. Im Zellenfeld Z wird ein unteres Segment 629 einer zweiten Leitung und in der Peripherie P eine zweite Metallisierungsebene 630 gebildet (siehe Figur 15). Es werden ganzflächig eine vierte Si₃N₄-Schicht 631 in einer Schichtdicke von 30 bis 50 nm und eine sechste SiO₂-Schicht 632 in einer Schichtdicke von 400 bis 800 nm abgeschieden. Darauf wird eine Maske 633 aus Photolack mit Hilfe photolithographischer Prozeßschritte hergestellt. Durch anisotropes Ätzen werden die sechste SiO₂-Schicht 632 und die vierte Si₃N₄-Schicht 631 strukturiert, wobei Gräben 632' gebildet werden (siehe Figur 16).

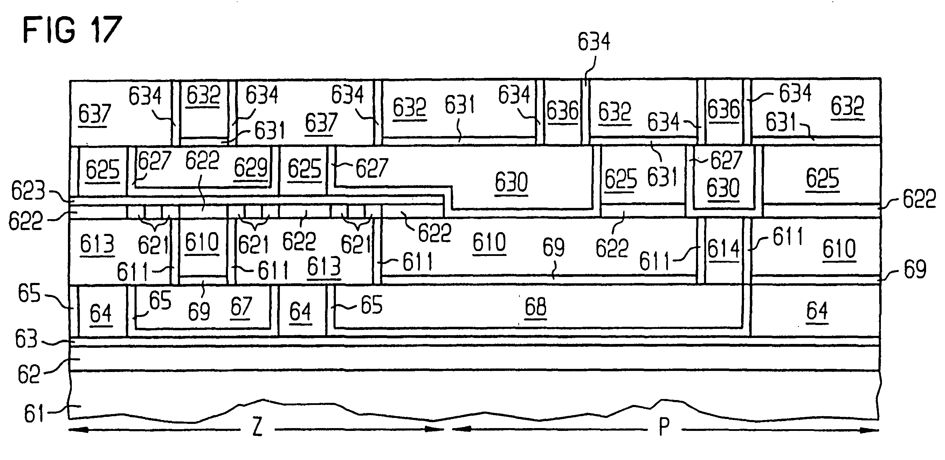

Nach Entfernen der Maske 633 werden an den Flanken der Gräben 632' eine vierte leitende Barriereschicht 634 und eine vierte leitende Schicht abgeschieden, die die Gräben 632' auffüllen. Die vierte leitende Barriereschicht 634 wird aus TaN/Ta in einer Schichtdicke von 50 nm gebildet. Der Boden der Gräben wird durch Sputter- und/oder RIE-Prozesse freigelegt. Die vierte leitende Schicht wird aus Kupfer in einer solchen Schichtdicke gebildet, daß die Gräben 632 aufgefüllt werden. Die vierte leitende Barriereschicht 634 und die vierte leitende Schicht werden durch CMP planarisiert, wobei die Oberfläche der sechsten SiO₂-Schicht 632 freigelegt wird. Gleichzeitig werden aus der vierten leitenden Schicht zweite Kontakte 636 in der Peripherie P und obere Segmente 637 der zweiten Leitung im Zellenfeld Z gebildet (siehe Figur 17).

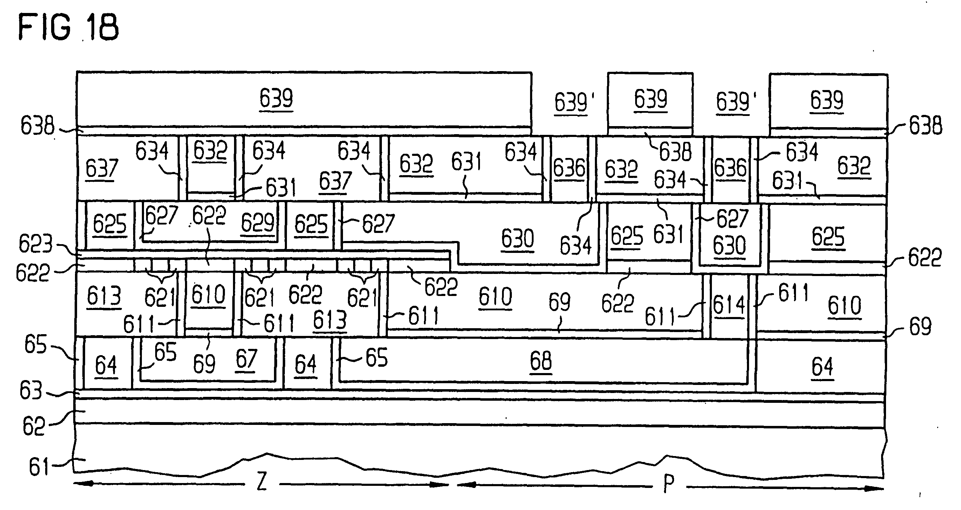

Es folgt die Abscheidung und Strukturierung einer fünften Si₃N₄-Schicht 638 in einer Dicke von 30 bis 50 nm und einer siebten SiO₂-Schicht 639 in einer Dicke von 400 bis 800 nm. Bei der Strukturierung mit Hilfe einer nicht dargestellten Photolackmaske und anistropem Ätzen werden Gräben 639 geöffnet, die auf zweite Kontakte 636 reichen (siehe Figur 18).

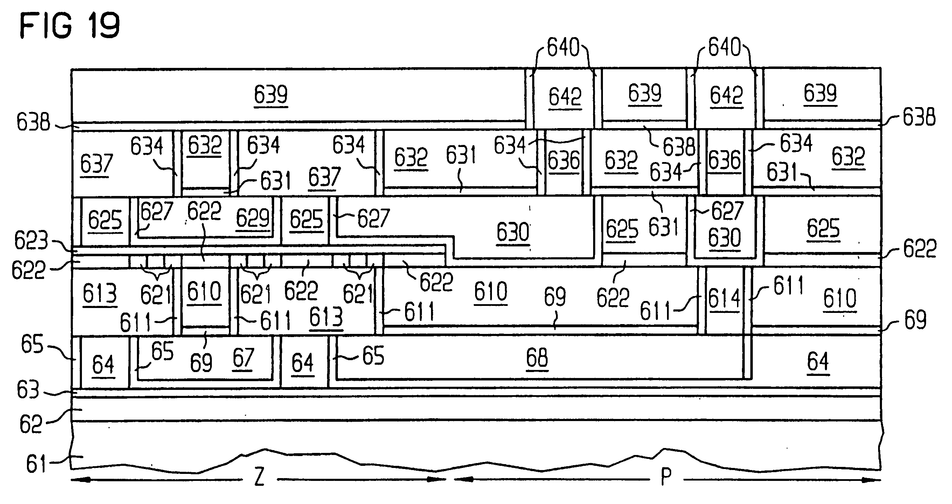

Durch Abscheidung und Planarisierung mit Hilfe von CMP von einer fünften leitenden Barriereschicht 640 aus Ta/TaN in einer Schichtdicke von 30 bis 50 nm und einer fünften leitenden Schicht aus Kupfer werden die Gräben 639' mit einer dritten Metallisierungsebene 642 aufgefüllt (siehe Figur 19).

Auf ein Substrat 71, das im Bereich der Oberfläche eine Diffusionsbarriereschicht aufweist, werden eine erste ferromagnetische Schicht 72 aus Co in einer Schichtdicke von 3 bis 10 nm, eine nichtmagnetische Schicht 73 aus Al₂O₃ in einer Schichtdicke von 1 bis 3 nm und eine zweite ferromagnetische Schicht 74 aus NiFe in einer Schichtdicke von 3 bis 10 nm aufgebracht (siehe Figur 20).

Auf die zweite ferromagnetische Schicht 74 wird eine Hilfsschicht 75 aus Si₃N₄ in einer Dicke von 50 bis 100 nm aufgebracht und mit Hilfe einer Photolackmaske (nicht dargestellt) strukturiert. Dabei wird in der Hilfsschicht 75 eine Öffnung erzeugt, in der die Oberfläche der zweiten ferromagnetischen Schicht 74 freigelegt ist.

Nachfolgend wird eine konforme Schicht 76 aus SiO₂ oder Ta in einer Schichtdicke von 80 bis 120 nm gebildet.

Durch anisotropes Ätzen (RIE) mit F- oder Cl-haltigen Reaktionsgasen wird aus der konformen Schicht 76 ein Spacer 77 gebildet, der herstellungsbedingt ringförmig ist (siehe Figur 21). Der Spacer 77 wird nach Entfernen der strukturierten Hilfsschicht 75 als Ätzmaske verwendet, um die zweite ferromagnetische Schicht 74, die nichtmagnetische Schicht 73 und die erste ferromagnetische Schicht 72 (eventuell einschließlich nicht gezeichneter Diffusionsbarrieren) zu strukturieren. Dabei wird ein ringförmiges, magnetoresistives Element 78 gebildet. Wenn der Spacer 77 aus Ta gebildet wurde, das Diffusionsbarrierewirkung aufweist, kann er als Diffusionsbarriere in der Speicherzellenanordnung verwendet werden.

Ein magnetoresistives Element 81, das einen ringförmigen Querschnitt aufweist, umfaßt mindestens ein erstes ferromagnetisches Schichtelement 82, ein nichtmagnetisches Schichtelement 83 und ein zweites ferromagnetisches Schichtelement 84, die als. Stapel übereinander angeordnet sind. Das erste ferromagnetische Schichtelement 82 weist eine Schichtdicke von 3 bis 10 nm, einen Außendurchmesser von 350 nm und einen Innendurchmesser von 100 bis 190 nm auf und enthält Co. Das nichtmagnetische Schichtelement 83 weist eine Dicke von 1 bis 3 nm auf und enthält Al₂O₃. Das zweite ferromagnetische Schichtelement 84 weist eine Dicke zwischen 3 und 10 nm auf und enthält NiFe. Das nichtmagnetische Schichtelement 83 und das zweite ferromagnetische Schichtelement 84 weisen den gleichen Querschnitt wie das erste ferromagnetische Schichtelement auf.

Das erste ferromagnetische Schichtelement 82 und das zweite ferromagnetische Schichtelement 84 können jeweils eine Magnetisierung im Uhrzeigersinn oder entgegen dem Uhrzeigersinn aufweisen. Stimmt die Magnetisierung des ersten ferromagnetischen Schichtelementes 82 mit der des zweiten ferromagnetischen Schichtelementes 84 in der Richtung überein, so weist das magnetoresistive Element 81 einen geringeren Widerstand auf, als wenn die Magnetisierungen des ersten ferromagnetischen Schichtelementes 82 und des zweiten ferromagnetischen Schichtelementes 84 entgegengesetzt ausgerichtet sind.

Zur Verstärkung der Vertikalkomponenten der Schreibströme in den ersten und zweiten Leitungen und der dadurch erzeugten azimutalen Magnetfelder am Ort der Speicherelemente, zur Einsparung einer photolithographischen Strukturierungsebene und zur sicheren lateralen Isolation der magnetoresistiven Elemente können folgende Prozeßmodifikationen des anhand von Figur 6 bis Figur 19 beschriebenen Prozeßablaufes durchgeführt werden:

Die zweite SiO₂-Schicht 64 wird mit größerer Dicke (zum Beispiel um den Faktor 2 dicker) abgeschieden. Dadurch entstehen tiefere Gräben 62' und nach dem CMP-Schritt entsprechend dikkere untere Segmente 67 der ersten Leitungen. Durch naßchemisches Rückätzen von Kupfer (zum Beispiel mit Ammonium-peroxodisulfat (NH₄)₂S₂O₆) wird die Oberfläche dieser Segmente unter die der zweiten SiO₂-Schicht 64 abgesenkt, so daß die Gräben 64' nur teilweise (zum Beispiel bis zur Hälfte) aufgefüllt sind. Anschließend werden die zweite Si₃N₄-Schicht 69 und die dritte SiO₂-Schicht 610 abgeschieden. Die weiteren Prozeßschritte erfolgen bis zur Fertigstellung der oberen Segmente 613 der ersten Leitungen im wesentlichen unverändert.

Nach Strukturierung der magnetoresistiven Elemente 621, bei der die Ringstruktur dieser Elemente mit Hilfe selbstjustierter Spacer erzeugt wurde, wird die vierte SiO₂-Schicht 622 durch einen anisotropen RIE-Prozeß (zum Beispiel unter Verwendung C- und F-haltiger Ätzgase) so zurückgeätzt, daß die magnetoresistiven Elemente 621 durch SiO₂-Spacer lateral isoliert werden. Anschließend wird die dritte Si₃N₄-Schicht 623 möglichst konform abgeschieden. Ohne diese Schicht zu strukturieren wird die fünfte SiO₂-Schicht 625 für die unteren Segmente der zweiten Leitungen abgeschieden und durch einen kurzen CMP-Schritte planarisiert. Dann werden die fünfte SiO₂-Schicht 625 selektiv zur dritten Si₃N₄-Schicht 623 und diese selektiv zu den SiO₂-Spacern der vierten SiO₂-Schicht 622 strukturiert.

Alle weiteren Prozeßschritte werden wie bereits beschrieben durchgeführt, wobei die Vertikalkomponenten des Schreibstromes in den zweiten Leitungen analog wie für die ersten Leitungen verstärkt werden.

## Patentansprüche

1. Speicherzellenanordnung
- mit mindestens einem magnetoresistiven Element (11), das einen in einer Schichtebene ringförmigen Querschnitt und Schichtelemente aufweist, die senkrecht zur Schichtebene übereinander gestapelt sind,
- mit mindestens einer ersten Leitung (12) und mindestens einer zweiten Leitung (13),
- bei der die erste Leitung (12) die zweite Leitung (13) kreuzt und das magnetoresistive Element (11) im Kreuzungsbereich zwischen der ersten Leitung und der zweiten Leitung angeordnet ist,
- bei der im Kreuzungsbereich die erste Leitung (12) und die zweite Leitung (13) bezüglich der Schichtebene auf unterschiedlichen Seiten des magnetoresistiven Elementes (11) angeordnet sind,
- bei der die erste Leitung (12) und/oder die zweite Leitung (13) im Überlappungsbereich mindestens einen ersten Leitungsanteil (131, 121), in dem eine parallel zur Schichtebene gerichtete Stromkomponente überwiegt, und einen zweiten Leitungsanteil (122, 132), in dem eine senkrecht zur Schichtebene gerichtete Stromkomponente überwiegt, aufweist/aufweisen.

2. Speicherzellenanordnung nach Anspruch 1,
- bei der der erste Leitungsanteil (131, 121) der ersten Leitung und/oder der zweiten Leitung jeweils parallel zu der Schichtebene verläuft,
- bei der der zweite Leitungsanteil (122, 132) der ersten Leitung und/oder der zweiten Leitung jeweils im Kreuzungsbereich zwischen der ersten Leitung und der zweiten Leitung eine zur Schichtebene parallele Ebene kreuzt.

3. Speicherzellenanordnung nach Anspruch 1 oder 2,
bei der der zweite Leitungsanteil (122, 132) jeweils im wesentlichen senkrecht zur Schichtebene verläuft.

4. Speicherzellenanordnung nach einem der Ansprüche 1 bis 3, bei der die erste Leitung (12) und die zweite Leitung (13) jeweils mindestens einen ersten Leitungsanteil (121, 131) und einen zweiten Leitungsanteil (122, 132) aufweisen, in denen eine parallel zur Schichtebene gerichtete Stromkomponente überwiegt bzw. eine senkrecht zur Schichtebene gerichtete Stromkomponente überwiegt.

5. Speicherzellenanordnung nach einem der Ansprüche 1 bis 4, bei der das magnetoresistive Element (11) zwischen die erste Leitung (12) und die zweite Leitung (13) geschaltet ist.

6. Speicherzellenanordnung nach einem der Ansprüche 1 bis 5, bei der das magnetoresistive Element (11) jeweils mindestens ein erstes ferromagnetisches Schichtelement (616), ein nichtmagnetisches Schichtelement (617) und ein zweites ferromagnetisches Schichtelement (618) aufweist, wobei das nichtmagnetische Schichtelement (617) zwischen dem ersten ferromagnetischen Schichtelement (616) und dem zweiten ferromagnetischen Schichtelement (618) angeordnet ist.

7. Speicherzellenanordnung nach Anspruch 6,
- bei der das erste ferromagnetische Schichtelement (616) und das zweite ferromagnetische Schichtelement (618) Fe, Ni, Co, Cr, Mn, Bi, Gd und/oder Dy enthalten,
- bei der das erste ferromagnetische Schichtelement (616) und das zweite ferromagnetische Schichtelement (618) senkrecht zur Schichtebene eine Dicke zwischen 2 nm und 20 nm aufweisen,
- bei der das nichtmagnetische Schichtelement (617) Al₂O₃, NiO, HfO₂, TiO₂, NbO, SiO₂, Cu, Au, Ag und/oder Al enthält und senkrecht zur Schichtebene eine Dicke zwischen 1 nm und 5 nm aufweist,
- bei der das erste ferromagnetische Schichtelement (616), das zweite ferromagnetische Schichtelement (618) und das nichtmagnetische Schichtelement (617) parallel zur Schichtebene Abmessungen zwischen 50 und 1000 nm aufweisen.

8. Speicherzellenanordnung nach einem der Ansprüche 1 bis 7,
- bei der eine Vielzahl gleichartiger magnetoresistiver Elemente (33, 41) vorgesehen ist, die matrixartig angeordnet sind,
- bei der eine Vielzahl gleichartiger erster Leitungen (31, 42) und gleichartiger zweiter Leitungen (32, 43) vorgesehen sind,
- bei der sich die ersten Leitungen (31, 42) und die zweiten Leitungen (32, 43) kreuzen,
- bei der im Kreuzungsbereich zwischen einer der ersten Leitungen (31, 42) und einer der zweiten Leitungen (32, 43) jeweils eines der magnetoresistiven Elemente (33, 41) angeordnet ist,
- bei der die ersten Leitungen und/oder die zweiten Leitungen jeweils alternierend erste Leitungsanteile, in denen eine parallel zur Schichtebene gerichtete Stromkomponente über wiegt, und zweite Leitungsanteile, in denen eine senkrecht zur Schichtebene gerichtete Stromkomponente über wiegt, aufweisen.

9. Speicherzellenanordnung nach Anspruch 8,
- bei der die ersten Leitungsanteile und die zweiten Leitungsanteile einer der ersten Leitungen und/oder einer der zweiten Leitungen so angeordnet sind, daß die betreffende Leitung in einer Ebene parallel zur Schichtebene einen streifenförmigen Querschnitt aufweist.

10. Speicherzellenanordnung nach Anspruch 8,
- bei der die magnetoresistiven Elemente (41) in Zeilen und Spalten angeordnet sind, wobei die Richtung der Zeilen und die Richtung der Spalten die Schichtebene aufspannen,
- bei der die Projektion der ersten Leitungsanteile einer der ersten Leitungen auf die Schichtebene jeweils zwischen benachbarten magnetoresistiven Elementen einer der Zeilen angeordnet ist, wobei die Projektion bezüglich einer Verbindungslinie zwischen den benachbarten magnetoresistiven Elementen (41) versetzt angeordnet ist,
- bei der die Projektion der ersten Leitungsanteile einer der zweiten Leitungen auf die Schichtebene jeweils zwischen benachbarten magnetoresistiven Elementen (41) einer der Spalten angeordnet ist, wobei die Projektion bezüglich einer Verbindungslinie zwischen den benachbarten magnetoresistiven Elementen seitlich versetzt angeordnet ist,
- bei der die Projektionen von entlang einer der Leitungen benachbarten ersten Leitungsanteilen auf die Schichtebene bezüglich der jeweiligen Verbindungslinien nach entgegengesetzten Seiten versetzt angeordnet sind.

11. Verfahren zur Herstellung einer Speicherzellenanordnung,
- bei dem auf einer Hauptfläche eines Substrats (61) eine erste Leitung erzeugt wird,
- bei dem durch Abscheiden und Strukturierung einer ersten ferromagnetischen Schicht (616), einer nichtmagnetischen Schicht (617) und einer zweiten ferromagnetischen Schicht (618) ein magnetoresistives Element gebildet wird, das in einer Schichtebene einen ringförmigen Querschnitt aufweist,
- bei dem eine zweite Leitung erzeugt wird, die die erste Leitung so kreuzt, daß das magnetoresistive Element im Kreuzungsbereich angeordnet ist,
- bei dem die erste und/oder zweite Leitung im Überlappungsbereich so erzeugt werden, daß sie mindestens einen ersten Leitungsanteil, in dem eine parallel zur Schichtebene gerichtete Stromkomponente überwiegt, und einen zweiten Leitungsanteil, in dem eine senkrecht zur Schichtebene gerichtete Stromkomponente überwiegt, aufweisen.

12. Verfahren nach Anspruch 11,
bei dem zur Strukturierung der ersten ferromagnetischen (616) Schicht, der nichtmagnetischen Schicht (617) und der zweiten ferromagnetischen Schicht (618) eine spacerförmige Maske verwendet wird.

13. Verfahren nach Anspruch 11 oder 12,
- bei dem zur Bildung der ersten Leitung eine erste leitende Schicht (67) abgeschieden und strukturiert wird, aus der ein unterer Bereich der ersten Leitung und in einer Peripherie der Speicherzellenanordnung eine erste Metallisierungsebene (68) gebildet werden,
- bei dem eine zweite leitende Schicht (613) abgeschieden und strukturiert wird, aus der ein oberer Bereich der ersten Leitung und in der Peripherie erste Kontakte (614) gebildet werden,
- bei der zur Bildung der zweiten Leitung eine dritte leitende Schicht abgeschieden und strukturiert wird, aus der ein unterer Bereich (629) der zweiten Leitung und in der Peripherie eine zweite Metallisierungsebene (630) gebildet werden,
- bei der eine vierte leitende Schicht abgeschieden und strukturiert wird, aus der ein oberer Bereich (637) der zweiten Leitung und in der Peripherie zweite Kontakte gebildet werden.

14. Verfahren nach Anspruch 13,
- bei dem vor der Abscheidung der ersten leitenden Schicht eine erste isolierende Schicht (64) abgeschieden und mit Hilfe photolithographischer Prozeßschritte so strukturiert wird, daß sie im Bereich der nachfolgend herzustellenden ersten Metallisierungsebene und des unteren Bereichs der ersten Leitung entfernt wird,
- bei dem die erste leitende Schicht durch ein planarisierendes Ätzverfahren strukturiert wird,
- bei dem vor der Abscheidung der zweiten leitenden Schicht eine zweite isolierende Schicht (610) abgeschieden und mit Hilfe photolithographischer Prozeßschritte so strukturiert wird, daß sie im Bereich der nachfolgend herzustellenden ersten Kontakten (614) und des oberen Bereichs der ersten Leitung entfernt wird,
- bei dem die zweite leitende Schicht durch ein planarisierendes Ätzverfahren strukturiert wird,
- bei dem vor der Abscheidung der dritten leitenden Schicht eine dritte isolierende Schicht (625) abgeschieden und mit Hilfe photolithographischer Prozeßschritte so strukturiert wird, daß sie im Bereich der nachfolgend herzustellenden zweiten Metallisierungsebene und des unteren Bereichs der zweiten Leitung entfernt wird,
- bei dem die dritte leitende Schicht durch ein planarisierendes Ätzverfahren strukturiert wird,
- bei dem vor der Abscheidung der vierten leitenden Schicht eine vierte isolierende Schicht (632) abgeschieden wird und mit Hilfe photolithographischer Prozeßschritte so strukturiert wird, daß sie im Bereich der nachfolgend herzustellenden zweiten Kontakte (636) und des oberen Bereichs der zweiten Leitung entfernt wird,
- bei dem die zweite leitende Schicht durch ein planarisierendes Ätzverfahren strukturiert wird.

15. Verfahren nach Anspruch 13 oder 14,
bei dem nach Fertigstellung der zweiten Leitung und Abscheidung und Strukturierung einer fünften leitenden Schicht in der Peripherie eine dritte Metallisierungsebene gebildet wird.

## Claims

1. Memory cell arrangement
- having at least one magnetoresistive element (11) which has a cross section that is annular in a layer plane and layer elements stacked one above the other perpendicularly to the layer plane,
- having at least one first line (12) and at least one second line (13),
- in which the first line (12) crosses the second line (13) and the magnetoresistive element (11) is arranged in the crossover region between the first line and the second line,
- in which, in the crossover region, the first line (12) and the second line (13) are arranged on different sides of the magnetoresistive element (11) with respective to the layer plane,
- in which the first line (12) and/or the second line (13) have/has, in the overlap region, at least one first line portion (131, 121), in which a current component directed parallel to the layer plane is predominant, and a second line portion (122, 132), in which a current component directed perpendicularly to the layer plane is predominant.

2. Memory cell arrangement according to Claim 1,
- in which the first line portion (131, 121) of the first line and/or of the second line in each case runs parallel to the layer plane,
- in which the second line portion (122, 132) of the first line and/or of the second line crosses a plane parallel to the layer plane in each case in the crossover region between the first line and the second line.

3. Memory cell arrangement according to Claim 1 or 2, in which the second line portion (122, 132) in each case runs essentially perpendicularly to the layer plane.

4. Memory cell arrangement according to one of Claims 1 to 3,
in which the first line (12) and the second line (13) in each case have at least one first line portion (121, 131) and a second line portion (122, 132), in which a current component directed parallel to the layer plane is predominant and, respectively, a current component directed perpendicularly to the layer plane is predominant.

5. Memory cell arrangement according to one of Claims 1 to 4,
in which the magnetoresistive element (11) is connected between the first line (12) and the second line (13).

6. Memory cell arrangement according to one of Claims 1 to 5,
in which the magnetoresistive element (11) in each case has at least one first ferromagnetic layer element (616), a non-magnetic layer element (617) and a second ferromagnetic layer element (618), the non-magnetic layer element (617) being arranged between the first ferromagnetic layer element (616) and the second ferromagnetic layer element (618).

7. Memory cell arrangement according to Claim 6,
- in which the first ferromagnetic layer element (616) and the second ferromagnetic layer element (618) contain Fe, Ni, Co, Cr, Mn, Bi, Gd and/or Dy,
- in which the first ferromagnetic layer element (616) and the second ferromagnetic layer element (618) have a thickness of between 2 nm and 20 nm perpendicularly to the layer plane,
- in which the non-magnetic layer element (617) contains Al₂O₃, NiO, HfO₂, TiO₂, NbO, SiO₂, Cu, Au, Ag and/or Al and has a thickness of between 1 nm and 5 nm perpendicularly to the layer plane,
- in which the first ferromagnetic layer element (616), the second ferromagnetic layer element (618) and the non-magnetic layer element (617) have dimensions of between 50 and 1000 nm parallel to the layer plane.

8. Memory cell arrangement according to one of Claims 1 to 7,
- in which a multiplicity of magnetoresistive elements (33, 41) of identical type are provided, which are arranged in the manner of a matrix,
- in which a multiplicity of first lines (31, 42) of identical type and second lines (32, 43) of identical type are provided,
- in which the first lines (31, 42) and the second lines (32, 43) cross one another,
- in which a respective one of the magnetoresistive elements (33, 41) is arranged in the crossover region between one of the first lines (31, 42) and one of the second lines (32, 43),
- in which the first lines and/or the second lines in each case alternately have first line portions, in which a current component directed parallel to the layer plane is predominant, and second line portions, in which a current component directed perpendicularly to the layer plane is predominant.

9. Memory cell arrangement according to Claim 8,
in which the first line portions and the second lines portions of one of the first lines and/or of one of the second lines are arranged in such a way that the relevant line has a strip-type cross section in a plane parallel to the layer plane.

10. Memory cell arrangement according to Claim 8,
- in which the magnetoresistive elements (41) are arranged in rows and columns, the direction of the rows and the direction of the columns spanning the layer plane,
- in which the projection of the first line portions of one of the first lines onto the layer plane is in each case arranged between adjacent magnetoresistive elements of one of the rows, the projection being arranged in offset fashion with respect to a connecting line between the adjacent magnetoresistive elements (41),
- in which the projection of the first line portions of one of the second lines onto the layer plane is in each case arranged between adjacent magnetoresistive elements (41) of one of the columns, the projection being arranged in laterally offset fashion with respect to a connecting line between the adjacent magnetoresistive elements,
- in which the projections of first line portions that are adjacent along one of the lines onto the layer plane are arranged in offset fashion with respect to the respective connecting lines on opposite sides.

11. Method for fabricating a memory cell arrangement,
- in which a first line is produced on a main area of a substrate (61),
- in which a magnetoresistive element having an annular cross section in a layer plane is formed by deposition and patterning of a first ferromagnetic layer (616), a non-magnetic layer (617) and a second ferromagnetic layer (618),
- in which a second line is produced, which crosses the first line in such a way that the magnetoresistive element is arranged in the crossover region,
- in which the first and/or second line are produced in the overlap region in such a way that they have at least one first line portion, in which a current component directed parallel to the layer plane is predominant, and a second line portion, in which a current component directed perpendicularly to the layer plane is predominant.

12. Method according to Claim 11,
in which a spacer-type mask is used for the patterning of the first ferromagnetic layer (616), the non-magnetic layer (617) and the second ferromagnetic layer (618).

13. Method according to Claim 11 or 12,
- in which, in order to form the first line, a first conductive layer (67) is deposited and patterned, from which a lower region of the first line and, in the periphery of the memory cell arrangement, a first metallization plane (68) are formed,
- in which a second conductive layer (613) is deposited and patterned, from which an upper region of the first line and, in the periphery, first contacts (614) are formed,
- in which, in order to form the second line, a third conductive layer is deposited and patterned, from which a lower region (629) of the second line and, in the periphery, a second metallization plane (630) are formed,
- in which a fourth conductive layer is deposited and patterned, from which an upper region (637) of the second line and, in the periphery, second contacts are formed.

14. Method according to Claim 13,
- in which, prior to the deposition of the first conductive layer, a first insulating layer (64) is deposited and patterned with the aid of photolithographic process steps in such a way that it is removed in the region of the first metallization plane that is subsequently to be fabricated and of the lower region of the first line,
- in which the first conductive layer is patterned by means of a planarizing etching method,
- in which, prior to the deposition of the second conductive layer, a second insulating layer (610) is deposited and patterned with the aid of photolithographic process steps in such a way that it is removed in the region of the first contacts (614) that are subsequently to be fabricated and of the upper region of the first line,
- in which the second conductive layer is patterned by means of a planarizing etching method,
- in which, prior to the deposition of the third conductive layer, a third insulating layer (625) is deposited and patterned with the aid of photolithographic process steps in such a way that it is removed in the region of the second metallization plane that is subsequently to be fabricated and of the lower region of the second line,
- in which the third conductive layer is patterned by means of a planarizing etching method,
- in which, prior to the deposition of the fourth conductive layer, a fourth insulating layer (632) is deposited and patterned with the aid of photolithographic process steps in such a way that it is removed in the region of the second contacts (636) that are subsequently to be fabricated and of the upper region of the second line,
- in which the second conductive layer is patterned by means of a planarizing etching method.

15. Method according to Claim 13 or 14,
in which a third metallization plane is formed after completion of the second line and deposition and patterning of a fifth conductive layer in the periphery.

## Revendications

1. Ensemble de cellules de mémoire
- comprenant au moins un élément (11) magnétorésistif qui a une section transversale annulaire dans un plan de couche et des éléments de couche qui sont empilés les uns sur les autres perpendiculairement au plan de couche ;
- comprenant au moins une première ligne (12) et au moins une deuxième ligne (13) ;
- dans lequel la première ligne (12) croise la deuxième ligne (13) et l'élément (11) magnétorésistif est disposé dans la zone d'intersection entre la première ligne et la deuxième ligne ;
- dans lequel dans la zone d'intersection, la première ligne (12) et la deuxième ligne (13) sont disposées par rapport au plan de couche sur des côtés différents de l'élément (11) magnétorésistif ;
- dans lequel la première ligne (12) et/ou la deuxième ligne (13) a ou ont, dans la zone de chevauchement, au moins une première partie (131, 121) de ligne, dans laquelle une composante de courant dirigée parallèlement au plan de couche est prépondérante et une deuxième partie (122, 132) de ligne, dans laquelle une composante de courant dirigée perpendiculairement au plan de couche est prépondérante.

2. Ensemble de cellules de mémoire suivant la revendication 1,
- dans lequel la première partie (131, 121) de ligne de la première ligne et/ou de la deuxième ligne s'étendent, respectivement, parallèlement au plan de couche ;
- dans lequel la deuxième partie (122, 132) de ligne de la première ligne et/ou de la deuxième ligne croise un plan parallèle au plan de couche dans la zone d'intersection entre la première ligne et la deuxième ligne.

3. Ensemble de cellules de mémoire suivant la revendication 1 ou 2, dans lequel la deuxième partie (122, 132) de ligne s'étend, respectivement, sensiblement perpendiculairement au plan de couche.

4. Ensemble de cellules de mémoire suivant l'une des revendications 1 à 3, dans lequel la première ligne (12) et la deuxième ligne (13) ont, respectivement, au moins une première partie (121, 131) de ligne et une deuxième partie (122, 132) de ligne, dans lesquelles une composante de courant dirigée parallèlement au plan de couche est prépondérante ou une composante de courant dirigée perpendiculairement au plan de couche est prépondérante.

5. Ensemble de cellules de mémoire suivant l'une des revendications 1 à 4, dans lequel l'élément (11) magnétorésistif est monté entre la première ligne (12) et la deuxième ligne (13).

6. Ensemble de cellules de mémoire suivant l'une des revendications 1 à 5, dans lequel l'élément (11) magnétorésistif a, respectivement, au moins un premier élément (616) ferromagnétique de couche, un élément (617) amagnétique de couche et un deuxième élément (618) ferromagnétique de couche, l'élément (617) amagnétique de couche étant disposé entre le premier élément (616) ferromagnétique de couche et le deuxième élément (618) ferromagnétique de couche.

7. Ensemble de cellules de mémoire suivant la revendication 6,
- dans lequel le premier élément (616) ferromagnétique de couche et le deuxième élément (618) ferromagnétique de couche contiennent du Fe, du Ni, du Co, du Cr, du Mn, du Bi, du Gb et/ou du Dy ;
- dans lequel le premier élément (616) ferromagnétique de couche et le deuxième élément (618) ferromagnétique de couche ont, perpendiculairement au plan de couche, une épaisseur comprise entre 2 nm et 20 nm ;
- dans lequel l'élément (617) amagnétique de couche contient de l'Al₂O₃, du NiO, du HfO₂, du TiO₂, du NbO, du SiO₂, du Cu, de l'Au, de l'Ag et/ou de l'Al et a, perpendiculaire au plan de couche, une épaisseur comprise entre 1 nm et 5 nm ;
- dans lequel le premier élément (616) ferromagnétique de couche, le deuxième élément (618) ferromagnétique de couche et l'élément (617) amagnétique de couche ont, parallèlement au plan de couche, des dimensions comprises entre 50 et 100 nm.

8. Ensemble de cellules de mémoire suivant l'une des revendications 1 à 7,
- dans lequel il est prévu une pluralité d'éléments (33, 41) magnétorésistifs de même type qui sont disposés en forme de matrice ;
- dans lequel il est prévu une pluralité de premières lignes (31, 42) de même type et de deuxièmes lignes (32, 43) de même type ;
- dans lequel les premières lignes (31, 42) et les deuxièmes lignes (32, 43) se croisent ;
- dans lequel, dans la zone d'intersection entre l'une des premières lignes (31, 42) et l'une des deuxièmes lignes (32, 43), est disposé, respectivement, l'un des éléments (33, 41) magnétorésistifs ;
- dans lequel les premières lignes et/ou les deuxièmes lignes ont, respectivement, en alternance des premières parties de ligne dans lesquelles une composante de courant dirigée parallèlement au plan de couche est prépondérante et des deuxièmes parties de ligne dans lesquelles une composante de courant dirigée perpendiculairement au plan de couche est prépondérante.

9. Ensemble de cellules de mémoire suivant la revendication 8,
- dans lequel les premières parties de ligne et les deuxièmes parties de ligne de l'une des premières lignes et/ou de l'une des deuxièmes lignes sont disposées de façon à ce que la ligne concernée ait une section transversale en forme de bande dans un plan parallèle au plan de couche.

10. Ensemble de cellules de mémoire suivant la revendication 8,
- dans lequel les éléments (41) magnétorésistifs sont disposés en lignes et en colonnes, la direction des lignes et la direction des colonnes étant dans le plan de couche ;
- dans lequel la projection des premières parties de ligne de l'une des premières lignes sur le plan de couche est disposée, respectivement, entre des éléments magnétorésistifs voisins de l'une des lignes, la projection étant décalée par rapport à une ligne de liaison entre les éléments (41) magnétorésistifs voisins ;
- dans lequel la projection des premières parties de ligne de l'une des deuxièmes lignes sur le plan de couche est disposée, respectivement, entre des éléments (41) magnétorésistifs voisins de l'une des lignes, la projection étant décalée latéralement par rapport à une ligne de liaison comprise entre les éléments magnétorésistifs voisins ;
- dans lequel les projections de premières parties de ligne voisines le long de l'une des lignes sur le plan de couche sont décalées par rapport aux lignes de liaison respectives vers des côtés opposés.

11. Procédé de production d'un ensemble de cellules de mémoire
- dans lequel on produit sur une surface principale d'un substrat (61) une première ligne ;
- dans lequel, par dépôt et structuration d'une première couche (616) ferromagnétique, d'une couche (617) amagnétique et d'une deuxième couche (618) ferromagnétique, on forme un élément magnétorésistif qui a, dans un plan de couche, une section transversale annulaire ;
- dans lequel on produit une deuxième ligne qui croise la première ligne de façon à ce que l'élément magnétorésistif soit disposé dans la zone d'intersection ;
- dans lequel on produit la première ligne et/ou la deuxième ligne dans la zone de chevauchement de façon à ce qu'elles aient au moins une première partie de ligne dans laquelle une composante de courant dirigée parallèlement au plan de couche est prépondérante et une deuxième partie de ligne dans laquelle une composante de courant dirigée perpendiculairement au plan de couche est prépondérante.

12. Procédé suivant la revendication 11,
- dans lequel, pour la structuration de la première couche (616) ferromagnétique, de la couche (617) amagnétique et de la deuxième couche (618) ferromagnétique, on utilise un masque en forme d'espaceur.

13. Procédé suivant la revendication 11 ou 12,
- dans lequel pour former la première ligne, on dépose et on structure une première couche (67) conductrice dans laquelle on forme une zone inférieure de la première ligne et dans une périphérie de l'ensemble de cellules de mémoire un premier plan (68) de métallisation ;
- dans lequel on dépose et on structure une deuxième couche (613) conductrice dans laquelle on forme une zone supérieure de la première ligne et à la périphérie de premiers contacts (614) ;
- dans lequel, pour former la deuxième ligne, on dépose et on structure une troisième couche conductrice dans laquelle on forme une zone (629) inférieure de la deuxième ligne et à la périphérie un deuxième plan (630) de métallisation ;
- dans lequel on dépose et on structure une quatrième couche conductrice dans laquelle on forme une zone (637) supérieure de la deuxième ligne et à la périphérie des deuxièmes contacts.

14. Procédé suivant la revendication 13,
- dans lequel, avant le dépôt de la première couche conductrice, on dépose une première couche (64) isolante et on la structure à l'aide de stades opératoires phôtolithographiques de façon à l'éliminer dans la zone du premier plan de métallisation et dans la zone inférieure de la première ligne à produire ensuite ;
- dans lequel on structure la première couche conductrice par un procédé d'attaque de planarisation ;
- dans lequel, avant le dépôt de la deuxième couche conductrice, on dépose une deuxième couche (610) isolante et on la structure à l'aide de stades opératoires de photolithographie de façon à l'éliminer dans la zone des premiers contacts (614) et dans la première zone supérieure de la première ligne à produire ensuite ;
- dans lequel on structure la deuxième couche conductrice par un procédé d'attaque de planarisation ;
- dans lequel, avant le dépôt de la troisième couche conductrice, on dépose une troisième couche (625) isolante et on la structure à l'aide de stades opératoires de photolithographie de façon à l'éliminer dans la zone du deuxième plan de métallisation et dans la zone inférieure de la deuxième ligne à produire ensuite ;
- dans lequel on structure la troisième couche conductrice par un procédé d'attaque de planarisation ;
- dans lequel, avant le dépôt de la quatrième couche conductrice, on dépose une quatrième couche (632) isolante et on la structure à l'aide de stades opératoires de photolithographie de façon à l'éliminer dans la zone des deuxièmes contacts (636) et dans la zone supérieure de la deuxième ligne à produire ensuite ;
- dans lequel on structure la deuxième couche conductrice par un procédé d'attaque de planarisation.

15. Procédé suivant la revendication 13 ou 14,
- dans lequel, après la finition de la deuxième ligne et le dépôt et la structuration d'une cinquième couche conductrice, on forme à la périphérie un troisième plan de métallisation.
